# EUROPEAN PATENT APPLICATION

(11) **EP 4 497 853 A1**
(43) Date of publication of application: **29.01.2025**
(21) Application number: 23773873.7
(22) Date of filing: 21.03.2023
(51) Int. Cl.: C30B 15/00, C30B 35/00

(54) **ARTIFICIAL CRYSTAL FURNACE, AND ARTIFICIAL CRYSTAL FURNACE SYSTEM COMPRISING ARTIFICIAL CRYSTAL FURNACE**

(30) Priority: 21.03.2022 CN 202210277537; 16.11.2022 CN 202223045663 U
(71) Applicant: Luoyang Changying New Energy Technology Co., Ltd., Luoyang, Henan 471000 (CN)
(72) Inventor: GUO, Liliang, Luoyang, Henan 471000 (CN); ZHU, Zhenye, Luoyang, Henan 471000 (CN)
(74) Representative: Cabinet Beau de Loménie
(86) International application number: PCT/CN2023/082895
(87) International publication number: WO 2023/179626

(57) **Abstract**

An artificial crystal furnace, and an artificial crystal furnace system comprising the artificial crystal furnace. The artificial crystal furnace comprises: a furnace body, comprising an upper furnace chamber, a lower furnace chamber, and a valve provided between the upper and lower furnace chambers, the valve being capable of dividing the upper furnace chamber and the lower furnace chamber into two independent cavities; a crystal cooling mechanism, provided in the furnace body and provided with at least one pulling hole for a pulled crystal to pass through; and a lifting and lowering apparatus, provided at the upper furnace chamber, connected to the crystal cooling mechanism, and driving the crystal cooling mechanism to move up and down in the upper furnace chamber and the lower furnace chamber. The crystal cooling mechanism is lifted to the upper furnace chamber above the valve by means of the lifting and lowering apparatus, so that continuous pulling of crystals or ingots can be implemented without stopping the furnace, and the problem that the cooling mechanism cannot be cleaned is effectively avoided; moreover, when water leakage occurs in a cooling shield, the cooling mechanism can be replaced without stopping the furnace, so that the possibility of explosion of the furnace body is avoided, and the production efficiency of the artificial crystal furnace is also improved.

## Description

### Cross-reference to Related Applications

The present application claims the benefits of the Chinese patent application No. 202210277537.7 filed on March 21, 2022 to the China National Intellectual Property Administration of the People's Republic of China and the Chinese patent application No. 202223045663.4 filed on November 16, 2022, the entire contents of which are hereby incorporated by reference in their entirety.

### Technical Field

The present application relates to the technical field of artificial crystal preparation, particularly to an artificial crystal furnace and an artificial crystal furnace system comprising the artificial crystal furnace.

### Background Art

The photovoltaic industry is becoming a "new favor" of the new energy industry, driven by the national macro-strategy policy of "peak carbon dioxide emissions and carbon neutrality". In this context, with the development of the photovoltaic industry, the global demand for polycrystalline silicon/single crystal silicon is growing rapidly, and the demand exceeds the supply in the market. Due to this influence, the price of polycrystalline silicon/single crystal silicon, which is the main raw material of solar cell, is rapidly rising, and many domestic enterprises are expanding the production.

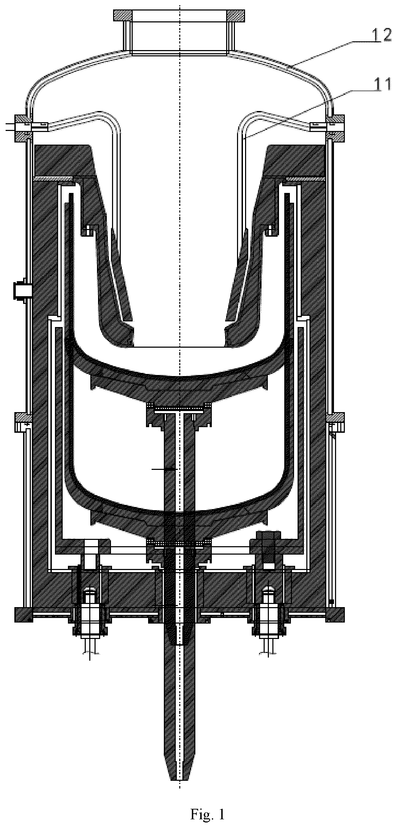

Taking polycrystalline silicon/single crystal silicon as an example, how to improve the crystal pulling speed is one of the key technologies in improving crystal pulling efficiency. When a silicon rod or silicon core is produced by a pulling method (i.e. placing a silicon material in a crucible and subjecting the same to heating and melting to form a silicon melt, then pulling the silicon rod or silicon core after contacting a seed crystal with the surface of the silicon melt, and under controlled conditions, continuously rearranging atoms or molecules at the interface between the seed crystal and the silicon melt, and gradually performing solidification with the temperature reduction such that a new silicon rod or silicon core grows), a cooling shield is widely used in the process of preparing the silicon rod or silicon core by the pulling method, and the main function is to improve the crystal growth rate and crystal growth quality and reduce costs. The application of the cooling shield has become the focus of technical innovation in this field. Through the application of the cooling shield, the pulling speed is made to advance from 1mm/min to 2mm/min. However, in practical applications, as shown in Fig. 1, the cooling shield 11 used by most enterprises is fixed on the inner wall of the lower furnace chamber 12, and the cooling shield 11 cannot be lifted and lowered, that is to say, it cannot achieve lifting and lowering.

The inventors have found through search the Chinese invention patent with the number 202110024156.3 and the filing date of January 8, 2021 entitled crystal growth furnace. This patent provides a technical solution that the cooling shield 11 can achieve a small range of lifting and lowering in the lower furnace chamber 12 such that accurate control over the crystal cooling process can be achieved, the crystal cooling speed can be effectively controlled, the crystal temperature distribution can be accurately adjusted, the flexibility of a thermal field is improved, and different products can be produced under the condition that the thermal field is not changed. The production and research and development costs are greatly reduced, and flow and position control can be carried out in different crystal growth stages so that the quality uniformity of the whole ingot is realized, and the overall utilization rate of the crystal is improved.

According to the Chinese invention patent, with the patent number 201520585827.3 and the application date of August 6, 2015 entitled an elevating gear for a draft pipe of Czochralski single crystal growing furnace, the invention is symmetrically horizontally installed on a furnace cover with two additional lifting ports. The guiding column, lead screw, and sliding block form a high-precision linear motion unit. One end of the lift bar is fixed on the sliding block, and the other end is connected to the lifting claw to achieve the up-and-down motion of the draft pipe; the upper end of the corrugated pipe is connected to the sliding block, and the other end is connected to the lifting port of the furnace cover. The O-ring sealing ensures the airtightness of the gear; and the rotary knob is connected to the lift bar to rotate the angle of the lifting claw, achieving the gripping and releasing action of the draft pipe. The synchronous action of the other lifting claw is achieved by a single motor driving the commutator, flexible axle, etc.

Through practical applications, it has been found that the above-mentioned two known solutions have the following technical defects when pulling a single ingot.
1. Since the lifting and lowering apparatus of the existing structure cannot lift the cooling shield above the furnace cover (wherein, in the technical solution disclosed in the invention entitled an elevating gear for a draft pipe of Czochralski single crystal growing furnace, the draft pipe can only be lifted and lowered below the furnace cover), when the cooling shield cannot be lifted above the furnace cover, the cooling shield cannot be cleaned without stopping the furnace. If the cooling shield cannot be cleaned, after the silicon material in the crucible melts to form a silicon liquid, impurities in the silicon liquid and in the furnace chamber volatilize and float to the surface of the cooling shield. Due to the cooling medium in the cooling shield, the temperature of the cooling shield is relatively low, in which case volatiles condense and adhere to the surface of the cooling shield. When the volatiles accumulate to a certain thickness, the same fall to the upper surface of the melt of the crucible and then float on the upper surface of the melt due to the turbulence of the gas flow and the effect of thermal expansion and contraction. Since the melting point of the volatiles is higher than the melting point of the silicon material, the volatiles cannot be melted, and further the volatiles cannot be vaporized, and the volatiles are continuously present on the upper surface of the molten liquid. As the crucible rotates at all times during the pulling, at this time the volatiles in the crucible will not be stationary at a certain point on the upper surface of the silicon melt, but will float at a variable position. Once the floater is attached to the crystallization position of the ingot, at this time the floater destroys the alignment direction of the molecules upon solidification of the silicon melt (dislocation occurring in the crystal direction), resulting in the fracture of the crystal line. At this time, the newly grown ingot is changed from a single crystal to a polycrystal, resulting in the failure of the growth of the single ingot.
2. In the pulling process, when water leakage occurs in the cooling shield, the cooling shield cannot be lifted out of the lower furnace chamber in time (namely, the cooling shield cannot be separated from the thermal field), and the silicon melt in the crucible can only be subjected to strong cooling by cutting off the water source and power supply. When the amount of water leakage is excessive, the cooling water is instantaneously vaporized when encountering a high temperature in the thermal field. At this time, if the gas generated from the gasification cannot be timely discharged out of the furnace chamber at the thermal field, the furnace body will explode.

When multiple silicon cores are simultaneously pulled by the Czochralski method, if the crystal cooling mechanism cannot lift out the lower furnace chamber, there are the following technical defects.
1. Since the lifting and lowering apparatus of the existing structure cannot lift the crystal cooling mechanism above the furnace cover (in the technical solution disclosed in the invention entitled an elevating gear for a draft pipe of Czochralski single crystal growing furnace, the draft pipe can only be lifted and lowered below the furnace cover), when the crystal cooling mechanism cannot be lifted above the furnace cover, the crystal cooling mechanism cannot be cleaned without stopping the furnace. After the silicon material in the crucible melts to form a silicon liquid, impurities in the silicon liquid and in the furnace chamber volatilize and float to the lower bottom surface or the side wall of the crystal cooling mechanism. Due to the cooling medium in the crystal cooling mechanism, the temperature of the crystal cooling mechanism is relatively low, in which case volatiles condense and adhere to the bottom surface or the side wall of the crystal cooling mechanism. When the volatiles accumulate to a certain thickness, the same fall to the upper surface of the melt of the crucible and then float on the upper surface of the melt due to the turbulence of the gas flow and the effect of thermal expansion and contraction. Since the melting point of the volatiles is higher than the melting point of the silicon material, the volatiles cannot be melted, and further the volatiles cannot be vaporized, and the volatiles are continuously present on the upper surface of the molten liquid. As the crucible rotates at all times during the pulling, at this time the volatiles in the crucible will not be stationary at a certain point on the upper surface of the silicon melt, but will float at a variable position. Once the floater is attached to the crystallization position of the silicon core, the light one causes the convex deformation of the outer edge face of the pulled silicon core. In severe cases, the silicon core is stuck in the crystal perforation due to the change in the diameter of the silicon core, and the pulling is finally forced to stop, thus ending the pulling of this round. The pulled silicon core cannot be used as a finished product and can only be scrapped.
2. Since the crystal cooling mechanism cannot be lifted out of the lower furnace chamber (i.e. the crystal cooling mechanism cannot be separated from the thermal field), and the crystal cooling mechanism is located above the crucible, when the crucible achieves continuous feeding, the crystal cooling mechanism blocks the channel of the continuous feeding apparatus such that the working condition requirements for continuous feeding to the crucible in the state of not stopping the furnace cannot be achieved.
3. When the adhesive substances on the crystal cooling mechanism are excessive, the furnace needs to be stopped to clean the adhesive substances, which seriously reduces the production efficiency of the silicon core, etc.

Therefore, how to provide a lifting and lowering apparatus for lifting a crystal cooling mechanism into an upper furnace chamber above a lower furnace chamber on the basis of lifting or lowering the cooling shield or the crystal cooling mechanism is one of the technical problems to be solved.

### Summary of the Invention

In order to solve the above-mentioned problems, the present application provides an artificial crystal furnace, which can conveniently achieve the lifting and lowering of a crystal cooling mechanism so as to better pull a crystal. The crystal cooling mechanism is lifted to the upper furnace chamber above the valve by means of the lifting and lowering apparatus, so that continuous pulling of crystals or ingots can be implemented without stopping the furnace, and the problem that the cooling mechanism cannot be cleaned is effectively avoided. Moreover, when water leakage occurs in a cooling shield, the cooling mechanism can be replaced without stopping the furnace, so that the possibility of explosion of the furnace body is avoided, and the production efficiency of the artificial crystal furnace is also improved.

According to one aspect of the present application, an artificial crystal furnace includes: a furnace body, the furnace body comprising an upper furnace chamber, a lower furnace chamber provided below the upper furnace chamber, and a valve provided between the upper furnace chamber and the lower furnace chamber, the valve being capable of dividing the upper furnace chamber and the lower furnace chamber into two independent cavities; a crystal cooling mechanism, provided in the furnace body and provided with at least one pulling hole for a pulled crystal to pass through; and a lifting and lowering apparatus, provided at the upper furnace chamber, connected to the crystal cooling mechanism, and driving the crystal cooling mechanism to move up and down in the upper furnace chamber and the lower furnace chamber.

Preferably, the lifting and lowering apparatus comprises at least one lifting and lowering arm connected to the crystal cooling mechanism and an elevator for driving the lifting and lowering arm to move up and down.

Preferably, the lifting and lowering apparatus is provided with a cooling medium channel, and the crystal cooling mechanism is provided with a cooling channel for cooling medium flow, the cooling medium channel being in fluid communication with the cooling channel.

Preferably, the lifting and lowering arm is provided in a linear structure or a fold-line-shaped structure.

Preferably, two lifting and lowering arms are provided.

Preferably, the cooling medium channel is provided on a side wall of the lifting and lowering arm or in a hollow structure of the lifting and lowering arm.

Preferably, the lifting and lowering arm is provided in a fold-line-shaped structure; at least one linear groove penetrating through an inner wall of the upper furnace chamber is provided on an outer edge face of the upper furnace chamber; a cover body is provided on the outer edge face of the upper furnace chamber at a periphery of the linear groove; and the fold-line segment of the lifting and lowering arm moves up and down in the linear groove.

Preferably, the upper furnace chamber is provided with at least one lifting and lowering arm cavity on an outer edge face of the upper furnace chamber; an inner cavity of the lifting and lowering arm cavity is provided integrally with an inner cavity of the upper furnace chamber; and the lifting and lowering arm is provided to be capable of moving up and down in a cavity formed by the inner cavity of the lifting and lowering arm cavity and the inner cavity of the upper furnace chamber.

Preferably, the lifting and lowering arm is provided in a rectilinear structure, an upper end of the lifting and lowering arm being connected to the elevator by penetrating through the top of the upper furnace chamber.

Preferably, the elevator comprises a hydraulic cylinder, an air cylinder, an electric push rod, a lead screw elevator, and an elevator for flexible shaft.

Preferably, the elevator comprises a lifting and lowering block, a power source, a support frame, a guide column, a lead screw, and a nut, wherein the support frame is provided on the outer side of the upper furnace chamber; two parallel guide columns are provided on the support frame; the lifting and lowering block is provided on two guide columns; the nut is provided on the lifting and lowering block; the nut is sleeved on the lead screw; an upper end and a lower end of the lead screw are respectively provided at an upper end and a lower end of the support frame; the lead screw is connected to the power source; and the lifting and lowering block is connected to the lifting and lowering arm.

Preferably, the elevator comprises a lifting and lowering block, a power source, a support frame, a guide column, an elevator for a flexible shaft, and a flexible shaft, wherein the support frame is provided on the outer side of the upper furnace chamber; two parallel guide columns are provided on the support frame; the lifting and lowering block is provided on the two guide columns; a flexible shaft is provided on the lifting and lowering block in a middle of two guide columns; the flexible shaft is connected to the elevator for flexible shaft provided on the support frame; the elevator for flexible shaft is externally connected to the power source; and the lifting and lowering block is connected to the lifting and lowering arm.

Preferably, the guide column comprises a linear guide rail, a linear bearing, and a guide feed rod.

Preferably, the valve comprises a gate valve, a rotary plate valve, and a flap valve.

Preferably, a sealing body is provided between the outer edge faces of the upper furnace chamber and the lifting and lowering arm.

Preferably, a bellows is sleeved on an outer edge face of the lifting and lowering arm, one end of the bellows is connected to the upper furnace chamber, and the other end of the bellows is connected to the elevator.

Preferably, a cooling jacket is provided to be connected between the crystal cooling mechanism and the lifting and lowering apparatus, the cooling jacket being used for cooling the crystal.

Preferably, the lifting and lowering apparatus comprises at least one lifting and lowering arm and an elevator for driving the lifting and lowering arm to move up and down; an upper end of the cooling jacket is connected to the lifting and lowering arm, and a lower end of the cooling jacket is connected to the crystal cooling mechanism; and an upper end of the lifting and lowering arm is connected to the elevator.

Preferably, a cooling medium channel is provided in the lifting and lowering arm, the cooling medium channel being in series communication with a medium channel of the cooling jacket and a cooling channel of the crystal cooling mechanism.

Preferably, a cooling medium channel is provided in the lifting and lowering arm, the cooling medium channel being in parallel communication with a medium channel of the cooling jacket and a cooling channel of the crystal cooling mechanism.

Preferably, the cooling jacket comprises an upper cover plate, a cooling jacket outer ring, a cooling jacket inner ring, and a lower cover plate, wherein the cooling jacket outer ring is sleeved at the periphery of the cooling jacket inner ring; the upper cover plate is provided at an upper end of a cavity between the cooling jacket outer ring and the cooling jacket inner ring; the lower cover plate is provided at a lower end of the cavity between the cooling jacket outer ring and the cooling jacket inner ring; and an upper inlet for cooling medium and an upper outlet for cooling medium are provided on the upper cover plate.

Preferably, the lower cover plate is provided with a lower outlet for cooling medium and a lower inlet for cooling medium.

Preferably, the cooling jacket further comprises a plurality of flow guide plates provided at intervals in the cavity between the cooling jacket outer ring and the cooling jacket inner ring, the plurality of flow guide plates being provided to contact the upper cover plate at its upper end in the cavities at positions in front of and behind the upper inlet for the cooling medium and the upper outlet for the cooling medium.

Preferably, the cooling jacket further comprises a spiral flow guide plate and a cooling medium return pipe provided in the cavity between the cooling jacket outer ring and the cooling jacket inner ring, the upper outlet for the cooling medium being connected to the cooling medium return pipe, and a lower end of the cooling medium return pipe passing through the spiral flow guide plate and being located in a lower middle portion of the cavity between the cooling jacket outer ring and the cooling jacket inner ring.

Preferably, the cooling jacket further comprises a spiral flow guide plate and a cooling medium flow guide pipe provided in the cavity between the cooling jacket outer ring and the cooling jacket inner ring, the upper outlet for the cooling medium being connected to the cooling medium flow guide pipe, and a lower end of the cooling medium flow guide pipe being connected to the lower inlet for the cooling medium by penetrating through the spiral flow guide plate.

Preferably, the cooling jacket comprises an upper cover plate, a cooling jacket outer ring, a cooling jacket inner ring, and a lower cover plate, wherein the cooling jacket outer ring is sleeved at the periphery of the cooling jacket inner ring; the upper cover plate is provided at an upper end of a cavity between the cooling jacket outer ring and the cooling jacket inner ring; the lower cover plate is provided at a lower end of a cavity between the cooling jacket outer ring and the cooling jacket inner ring; an upper inlet for the cooling medium and an upper outlet for the cooling medium are provided on an outer edge face of the cooling jacket outer ring; and a lower outlet for the cooling medium and a lower inlet for the cooling medium are provided on the lower cover plate.

According to another aspect of the present application, there is provided an artificial crystal furnace system including the artificial crystal furnace as described above.

According to the present application, it achieves the cleaning of volatiles attached to the crystal cooling mechanism without stopping the furnace by providing a valve between the upper furnace chamber and the lower furnace chamber, then connecting the crystal cooling mechanism to the lifting and lowering apparatus, and moving the crystal cooling mechanism up and down within the cavities of the upper furnace chamber and the lower furnace chamber by the lifting and lowering apparatus. At the same time, it also avoids the absorption of the heat from the heater by the crystal cooling mechanism, etc. during heating, thereby reducing manual labor intensity and improving production efficiency.

Furthermore, according to the present application, when water leakage occurs in the cooling mechanism during pulling, the crystal cooling mechanism can be lifted out of the lower furnace chamber by means of the lifting and lowering apparatus. Therefore, the problem that the cooling water is instantaneously vaporized at a high temperature in the thermal field when water leakage occurs in the cooling apparatus, the possibility of explosion of the furnace body, and the like are effectively avoided.

Furthermore, according to the present application, through the arrangement of a lifting and lowering apparatus, the crystal cooling mechanism can be lifted out of the lower furnace chamber, so as to provide a feeding channel for the continuous feeding apparatus when the crucible achieves continuous feeding, thereby achieving the working condition requirements for continuous feeding of the crucible under the state of not stopping the furnace.

In addition, according to the present application, a cooling jacket is provided above the cooling apparatus, and the ingot is cooled by the cooling jacket and the cooling apparatus, so that the cooling rate of the ingot is increased, thereby improving the pulling efficiency of the ingot.

### Brief Description of the Drawings

Fig. 1 is a schematic view showing a structure of the arrangement of an existing cooling shield in a furnace body;
Fig. 2 is a schematic view of the structure of a lifting and lowering apparatus in a lower position according to a first embodiment of the present application;
Fig. 3 is a schematic view of the structure of the lifting and lowering apparatus in an upper position according to the first embodiment of the present application;
Fig. 4 is a schematic view of a three-dimensional structure of a cover body according to the first embodiment of the present application;
Fig. 5 is a schematic view of a second structure of an upper furnace chamber according to the first embodiment of the present application;
Fig. 6 is a schematic view of a third structure of the upper furnace chamber according to the first embodiment of the present application;
Fig. 7 is a schematic view of the structure of the lifting and lowering apparatus according to the first embodiment of the present application;
Fig. 8 is a schematic view of the right-view structure of Fig. 4;
Fig. 9 is a schematic view of the structure of a lifting and lowering block according to the first embodiment of the present application;
Fig. 10 is a schematic view of a second structure of the lifting and lowering apparatus according to the first embodiment of the present application;
Fig. 11 is a schematic view of the structure of a lifting and lowering apparatus in a lower position according to a second embodiment of the present application;
Fig. 12 is a schematic view of the structure of the lifting and lowering apparatus in an upper position according to the second embodiment of the present application;
Fig. 13 is a schematic view of a first structure of a cooling jacket according to the second embodiment of the present application;
Fig. 14 is a schematic view of a second structure of a cooling jacket according to the second embodiment of the present application;
Fig. 15 is a schematic view of a third structure of a cooling jacket according to the second embodiment of the present application;
Fig. 16 is a schematic view of the top-view structure of Fig. 15;
Fig. 17 is a schematic view of a fourth structure of a cooling jacket according to the second embodiment of the present application;
Fig. 18 is a schematic view of a fifth structure of a cooling jacket according to the second embodiment of the present application;
Fig. 19 is a schematic view of a sixth structure of a cooling jacket according to the second embodiment of the present application;
Fig. 20 is a schematic view showing an application of pulling an ingot using a lifting and lowering apparatus according to the second embodiment of the present application;
Fig. 21 is a schematic view of the structure of a combination of the crystal cooling mechanism and the cooling jacket shown in Fig. 20;
Fig. 22 is a schematic view showing an application of pulling an ingot using a cooling jacket alone according to the second embodiment of the present application;
Fig. 23 is a schematic view showing the structure of an upper furnace chamber rotating away from a lower furnace chamber after a cooling jacket is raised to be into the upper furnace chamber driven by the lifting and lowering mechanism according to the second embodiment of the present application; and
Fig. 24 is a schematic view showing an application of pulling a plurality of crystals according to the second embodiment of the present application.

### Detailed Description of the Invention

The present application is described in detail below by way of embodiments, without implying that there are any disadvantageous limitations to the present application. While the present application has been described in detail and specific embodiment modes thereof have been disclosed as well, it will be apparent to those skilled in the art that various changes and modifications can be made in the specific implementation modes of the present application without departing from the spirit and scope of the present application.

In the description of the present invention, it needs to be understood that the orientation or positional relationships indicated by the terms "center", "lateral", "length", "width", "height", "up", "down", "front", "back", "left", "right", "vertical", "horizontal", "top", "bottom", "inside", "outside", "side", etc. are based on the orientation or positional relationship shown in the drawings and are only for the convenience of describing the invention and simplifying the description, rather than indicating or implying that the referred equipment or element must have a specific orientation, or be constructed and operated in a specific orientation, and therefore cannot be construed as a limitation of the present invention.

In describing the present invention, it further needs to be noted that unless otherwise expressly specified and limited, the terms "provided", "mounted" "connected", and "connecting" should be interpreted broadly. For example, it can be a fixed connection or a detachable connection, or an integrated connection; it can be a mechanical connection, or an electrical connection; it can be directly connected or indirectly connected through an intermediate medium, and it can be the communication within two elements. For persons skilled in the art, the specific meaning of the above-mentioned terms in the present invention can be understood according to specific situations. It needs to be noted that the present application relates not only to a single crystal furnace but also to a crystal furnace capable of simultaneously pulling a plurality of crystals. In the case of a single crystal furnace, the upper furnace chamber referred to below corresponds to a minor furnace chamber in the single crystal furnace, and the lower furnace chamber corresponds to a main furnace chamber in the single crystal furnace.

According to the present application, there is provided an artificial crystal furnace, including: a furnace body including an upper furnace chamber, a lower furnace chamber provided below the upper furnace chamber, and a valve provided between the upper furnace chamber and the lower furnace chamber, the valve being capable of dividing the upper furnace chamber and the lower furnace chamber into two independent cavities; a crystal cooling mechanism, provided in the furnace body and provided with at least one pulling hole for a pulled crystal to pass through; and a lifting and lowering apparatus, provided at the upper furnace chamber, connected to the crystal cooling mechanism, and driving the crystal cooling mechanism to move up and down in the upper furnace chamber and the lower furnace chamber.

According to the present application, by providing the lifting and lowering apparatus, the lifting and lowering of the crystal cooling mechanism can be conveniently achieved, thereby better pulling the crystal.

In addition, according to the present application, the crystal cooling mechanism can be lifted to the upper furnace chamber above the valve by means of the lifting and lowering apparatus, so that continuous pulling of crystals or ingots can be implemented without stopping the furnace, and the problem that the cooling mechanism cannot be cleaned is effectively avoided; moreover, when water leakage occurs in a cooling shield, the cooling mechanism can be replaced without stopping the furnace, so that the possibility of explosion of the furnace body is avoided, and the production efficiency of the artificial crystal furnace is also improved.

Hereinafter, specific structures of preferred embodiments of the present application will be described in detail with reference to the accompanying drawings and embodiments.

### First Embodiment

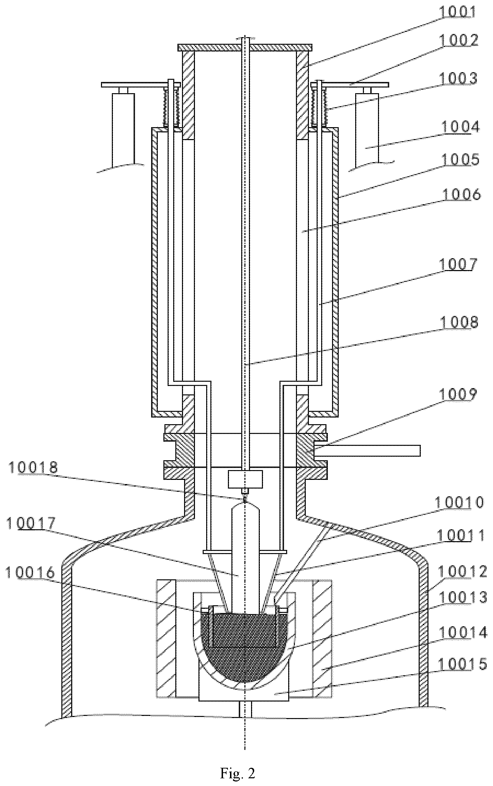

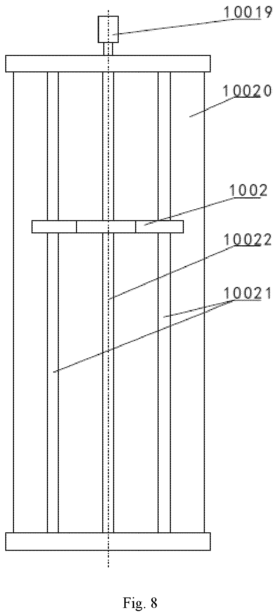

Figs. 2 to 10 show schematic views of a lifting and lowering apparatus provided with a crystal cooling mechanism for an artificial crystal furnace according to preferred embodiments of the present application.

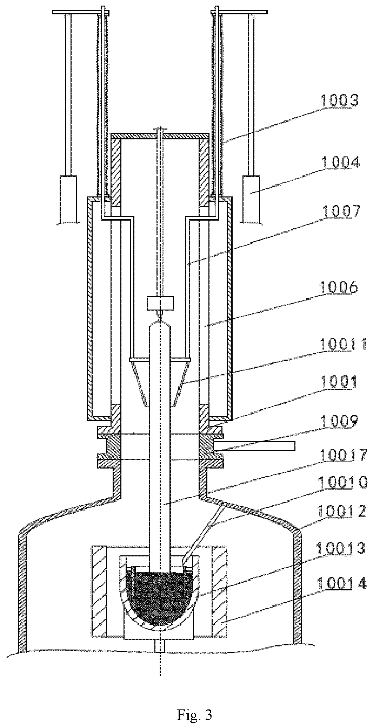

As shown in Figs. 2 and 3, according to one embodiment of the present application, an artificial crystal furnace may include an upper furnace chamber 1001, a crystal cooling mechanism 10011, a lifting and lowering apparatus connected to the crystal cooling mechanism 10011, and a lower furnace chamber 10012. The lifting and lowering apparatus comprises an elevator 1004 and a lifting and lowering arm 1007. The upper furnace chamber 1001 is provided above the lower furnace chamber 10012, and a valve is provided between a lower end face of the upper furnace chamber 1001 and an upper end face of the lower furnace chamber 10012. Through the valve, the upper furnace chamber and the lower furnace chamber can be divided into two independent cavities. The valves may include a gate valve 1009, a rotary plate valve, and a flap valve. In practice, the main function of the valve is to divide the cavities of the upper furnace chamber 1001 and the lower furnace chamber 10012 into two independent cavities. Namely, when the valve is opened, the cavities of the upper furnace chamber 1001 and the lower furnace chamber 10012 communicate to form one integral cavity; and when the valve is closed, the cavities of the upper furnace chamber 1001 and lower furnace chamber 10012 are divided into two independent cavities. An embodiment of the present application is illustrated with the valve being a gate valve 1009 as an example. A furnace door that can be opened and closed is provided on the outer edge face of the upper furnace chamber 1001 through a hinge. The lifting and lowering apparatus according to the present application is connected to the crystal cooling mechanism 10011, and drives the crystal cooling mechanism 10011 to move up and down in the cavities of the upper furnace chamber 1001 and the lower furnace chamber 1002.

Further, at least one lifting and lowering arm 1007 is provided in the upper furnace chamber 1001, and the lifting and lowering arm 1007 is connected to the crystal cooling mechanism. In specific implementations, a cooling medium channel may be provided on the side wall of the lifting and lowering arm 1007. Alternatively, the lifting and lowering arm 1007 is provided as a hollow structure, and the inner hole in the middle of the lifting and lowering arm 1007 is a cooling medium channel. The lower end of the cooling medium channel is connected to a medium outlet or medium inlet on the crystal cooling mechanism 10011, and the upper end of the cooling medium channel is connected to a cooling source. That is, the cooling medium introduced in the crystal cooling mechanism 10011 is transferred through the cooling medium channel on the lifting and lowering arm 1007.

When one lifting and lowering arm 1007 is provided, two cooling medium channels for letting in and out are provided on the lifting and lowering arm 1007. An upper port of one cooling medium channel is connected to the cooling source, a lower port is connected to a medium inlet on the crystal cooling mechanism 10011, a lower port of the other cooling medium channel is connected to a medium outlet on the crystal cooling mechanism 10011, and an upper port is connected to a recovery port of the cooling source. Namely, two cooling medium channels, one in and one out, form one medium flowing channel with the crystal cooling mechanism 10011.

When two lifting and lowering arms 1007 are provided, one cooling medium channel is provided on each of the two lifting and lowering arms 1007. The two cooling medium channels are one in and one out and also form one medium flowing channel. The structure of the crystal cooling mechanism 10011 involved in the present invention will not be described in detail herein, and its specific structure is not the focus of the present invention. In addition, the cooling shield or crystal cooling mechanism according to this embodiment each has one or more pulling holes through which an ingot passes.

In an implementation, as shown in Figs. 2, 3, 5, and 6, a case where two lifting and lowering arms 1007 are provided will be described as an example. Two lifting and lowering arms 1007 are provided in the upper furnace chamber 1001, and preferably, the two lifting and lowering arms 1007 are symmetrically provided in the upper furnace chamber 1001. The connection forms involving the lifting and lowering arm 1007 and the crystal cooling mechanism 10011 are various, and are also conventional connection forms in the art, such as a threaded connection or a welded connection, etc.; however, it must be ensured that no medium leakage occurs after the connection, and the tightness of the connection must be ensured. In a specific implementation, the number of the lifting and lowering arms 1007 is preferably two, and the two lifting and lowering arms 1007 are symmetrically provided, so that it can be ensured that the crystal cooling mechanism 10011 can be lifted and lowered smoothly and the economic efficiency and the practicability are optimal. Similarly, three or more lifting and lowering arms may alternatively be selected to be used, all within the scope of the present invention. When one lifting and lowering arm 1007 is provided, the lifting and lowering of the lifting and lowering arm 1007 can also be realized, which is also within the scope of the present invention.

Furthermore, the lower end head of the lifting and lowering arm 1007 is connected to the crystal cooling mechanism 10011 and drives the crystal cooling mechanism 10011 to move up and down in the cavities of the upper furnace chamber 1001 and the lower furnace chamber 10012. That is to say, it can be achieved that the lifting and lowering arm 1007 drives the crystal cooling mechanism 10011 to move up into the upper furnace chamber 1001 and completely disengage from the lower furnace chamber 10012. The upper end head of the lifting and lowering arm 1007 is connected through the upper furnace chamber 1001 to an elevator 1004 provided outside the upper furnace chamber 1001. The lifting and lowering arm 1007 is driven to move up and down by the elevator 1004. The main function of the elevator 1004 is to drive the lifting and lowering arm to move up and down, and a sealing body is provided between the outer edge faces of the upper furnace chamber 1001 and the lifting and lowering arm 1007.

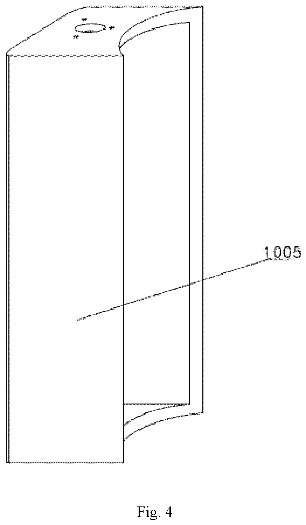

Further, as shown in Figs. 2, 3, 5, and 6, the lifting and lowering arm 1007 may be provided in a linear structure or a fold-line-shaped structure. When the lifting and lowering arm 1007 is provided as a fold-line-shaped structure, it can be seen from the figures that the main function of the fold-line-shaped structure is to enable the connection of the elevator 1004 and the crystal cooling mechanism 10011 which are not on the same straight line. In practical applications, the fold-line segment referred to, whether it is a straight-line bend or an arc bend or a diagonal bend, is within the scope of the present invention. At least one linear groove 1006 through the inner wall of the upper furnace chamber 1001 is provided on the outer edge face of the upper furnace chamber 1001. In an implementation, the number of linear grooves 1006 is preferably two, and the two linear grooves 1006 are symmetrically provided, and a cover body 1005 is provided on the outer edge face of the upper furnace chamber 1001 around the periphery of the linear grooves 1006. The fold-line-shaped structure of the lifting and lowering arm 1007 moves up and down in the linear groove 1006. The upper end head of the lifting and lowering arm 1007 passes through the upper end face of the cover body 1005 and is connected and provided to the elevator 1004 located outside the cover body 1005. In an implementation, the specific structure of the cover body 1005 is shown in Fig. 4. The cover body 1005 may be welded to the outer edge face of the upper furnace chamber 1001 so that the inner cavity of the cover body 1005 and the inner cavity of the upper furnace chamber 1001 form one integral cavity through the linear groove 1006. A lifting and lowering arm perforation for accommodating the lifting and lowering arm 1007 to move up and down is provided on the upper end face of the cover body 1005. A sealing body is provided in the lifting and lowering arm perforation, and the main function of the sealing body is to ensure that the integral cavity formed by the upper furnace chamber 1001 and the cover body 1005 is one sealed cavity, that is to say, to ensure that when the lifting and lowering arm 1007 moves up and down, no leakage occurs in the sealed cavity. The sealing body may be selected from a sealing ring or an O-shaped ring or a shaft seal, etc. as long as the sealing effect is achieved.

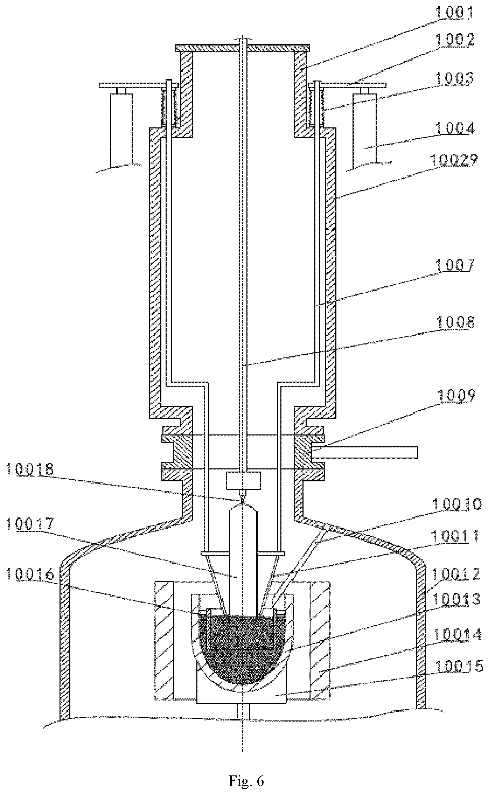

Alternatively, in a specific implementation, as shown in Fig. 6, an alternative structure of the upper furnace chamber 1001 is to provide at least one lifting and lowering arm cavity 10029 on the outer edge face of the upper furnace chamber 1001. The lifting and lowering arm cavity 10029 is of annular or linear structure. The inner cavity of the lifting and lowering arm cavity 10029 and the inner cavity of the upper furnace chamber 1001 are provided to be integral to form one entire cavity. An elevator 1004 is provided above the lifting and lowering arm cavity 10029, and the elevator 1004 is connected to the upper end head of the lifting and lowering arm 1007. That is, the main function of the lifting and lowering arm cavity 10029 is to form one space for the lifting and lowering arm 1007 to move up and down, and its specific structural form may be provided as an annular structure, or any other various shapes may be selected as long as it can ensure that the lifting and lowering arm 1007 moves up and down in the upper furnace chamber 1001. Also, it is possible to achieve this effect by integrally enlarging the diameter of the upper furnace chamber 1001. However, increasing the diameter of the upper furnace chamber 1001 as a whole may result in slightly lower economic efficiency, but this structure is also within the scope of protection of the present invention.

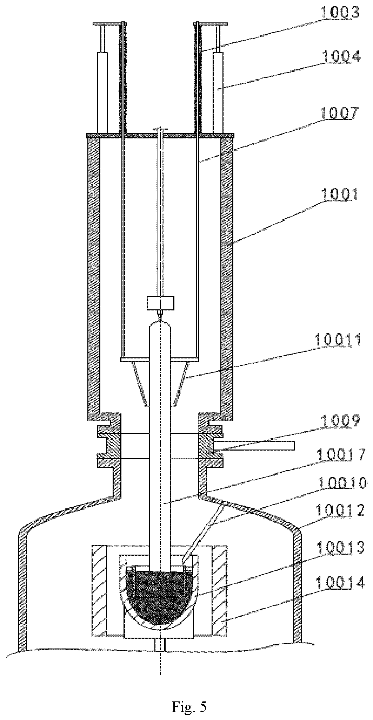

Further, as shown in Fig. 5, when the lifting and lowering arm 1007 is provided in a linear structure, the upper portion of the lifting and lowering arm 1007 is connected to the elevator 1004 provided at the top of the upper furnace chamber 1001 through the top of the upper furnace chamber 1001. It could be understood that in this form of structure, the lifting and lowering arm 1007 may also be provided in a fold-line-shaped structure.

Further, the elevator 1004 is any one of a hydraulic cylinder or an air cylinder or an electric push rod or a lead screw elevator or an elevator for flexible shaft. In an implementation, when the elevator 1004 is provided as a hydraulic cylinder or air cylinder or an electric push rod, it may be directly connected to the upper end head of the lifting and lowering arm 1007. At this time, the up-and-down movement of the lifting and lowering arm 1007 can be achieved by simply providing the hydraulic cylinder or the air cylinder or the electric push rod above the upper furnace chamber, then providing the hydraulic cylinder or the air cylinder or the electric push rod on one bracket, and then connecting the telescopic rod of the hydraulic cylinder or the air cylinder or the electric push rod to the upper end head of the lifting and lowering arm 1007. When the hydraulic cylinder or air cylinder or electric push rod is provided on the upper furnace chamber 1001 or a support frame on the rack, the telescopic rod on the hydraulic cylinder or the air cylinder or the electric push rod is connected to the lifting and lowering block 1002, and the lifting and lowering block 1002 is connected to the upper end head of the lifting and lowering arm 1007, so that the lifting and lowering arm 1007 moves up and down.

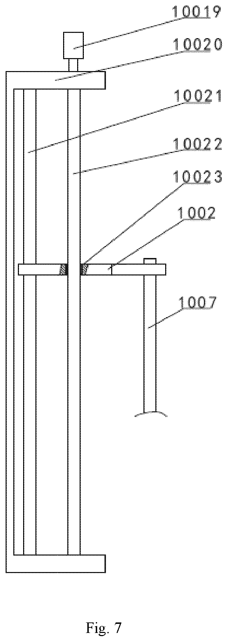

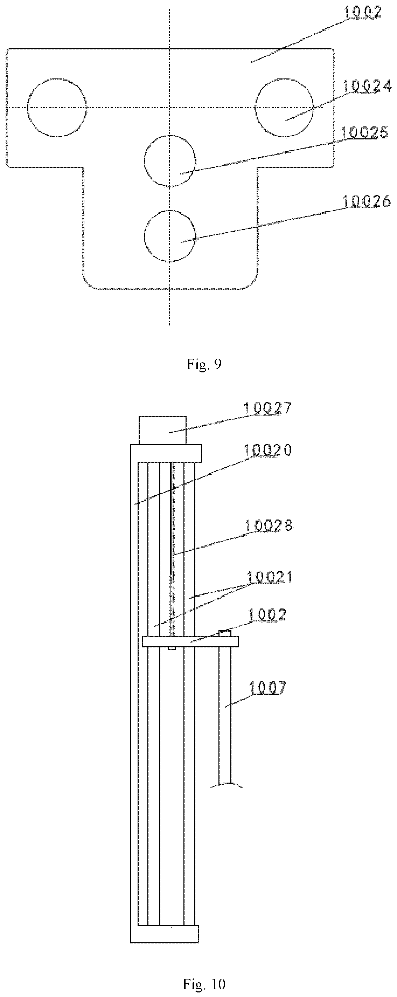

Further, as shown in Figs. 7, 8, and 9, the lead screw elevator comprises a lifting and lowering block 1002, a power source 10019, a support frame 10020, a guide column 10021, a lead screw 10022, and a nut 10023. The support frame 10020 is provided on the outer side of the upper furnace chamber 1001. For example, it can be provided on the bracket of the rack or directly on the rack. Two parallel guide columns 10021 are provided on the support frame 10020, a lifting and lowering block 1002 is provided on the two guide columns 10021, a nut 10023 is provided on the lifting and lowering block 1002, and the nut 10023 is sleeved on the lead screw 10022. The upper end and lower end of the lead screw 10022 are respectively provided at the upper end and lower end of the support frame 10020, and the upper end head or the lower end head of the lead screw 10022 is connected to the power source 10019. The power source 10019 is preferably a motor, but it is also possible to provide a reducer between the motor and the lead screw. The lifting and lowering block 1002 is connected to the upper end head of the lifting and lowering arm 1007. In an implementation, the alternative structures of the guide column 10021 are a linear guide rail, a linear bearing, and a guide feed rod. The structure of the lifting and lowering block 1002 is as shown in Fig. 9. The lifting and lowering block 1002 has a rectangular structure, and two guide holes 10024 for mounting guide columns 10021 are provided on the upper face of the lifting and lowering block 1002. A nut fixing hole 10025 is provided in the middle of the lifting and lowering block 1002, and a nut 10023 is provided in the nut fixing hole 10025. A lifting and lowering arm fixing hole 10026 is provided at the front end of the nut fixing hole 10025, and the lifting and lowering arm fixing hole 10026 is connected to the lifting and lowering arm 1007.

Further, as shown in Fig. 10, the elevator for flexible shaft includes a lifting and lowering block 1002, a power source 10019, a support frame 10020, a guide column 10021, an elevator for flexible shaft 10027, and a flexible shaft 10028. The support frame 10020 is provided on the outer side of the upper furnace chamber 1001, two parallel guide columns 10021 are provided on the support frame 10020, and a lifting and lowering block 1002 is provided on the two guide columns 10021. A flexible shaft 10028 is installed on the lifting and lowering block 1002 between the two guide columns 10021. The upper end head of the flexible shaft 10028 is connected to an elevator for flexible shaft 10027 provided on the top face of the support frame 10020, and the elevator for flexible shaft 10027 is externally connected to the power source 10019. The lifting and lowering block 1002 is connected to the upper end head of the lifting and lowering arm 1007. In an implementation, alternative structures of the guide columns 10021 may be chosen to be linear guide rail likewise. The elevator for flexible shaft 10027 is also directly available in the market by purchasing, and its structure includes a housing, a flexible shaft roller, a ball spline, and a nut. For example, one flexible shaft roller is placed in the housing, and the flexible shaft roller is sleeved on the ball spline, and the ball spline is driven by the power source 10019 to realize forward rotation or reverse rotation. An external thread is provided on one end of the flexible shaft roller, the external thread cooperates with a nut, the nut is fixed in the housing, and the flexible shaft 10028 is wound on the flexible shaft roller. During winding, the flexible shaft roller makes a left-right movement while making a rotation movement on the ball spline, so as to ensure that the lower end head of the flexible shaft 10028 does not make a left-right movement, but only makes an up-down movement.

Further, in order to improve the sealing performance of the upper furnace chamber 1001, a bellows 1003 is sleeved on the outer edge face of the lifting and lowering arm 1007. The upper end head of the bellows 1003 is connected to the lifting and lowering block 1002 in the elevator 1004, and the lower end head of the bellows 1003 is connected to the upper furnace chamber 1001.

In a specific application of the present invention, as shown in Figs. 2 and 3, a crucible support seat 10015 is provided in the lower furnace chamber 10012, and a supported crucible 10013 is provided on the crucible support seat 10015. An isolating sleeve 10016 is provided inside the crucible 10013, and a heater 10014 is provided at the periphery of the crucible 10013. The lower furnace chamber 10012 is further provided with a feeding pipe 10010, one end (upper end in the figure) of the feeding pipe 10010 is connected to an automatic feeding apparatus outside the furnace, and the other end (lower end in the figure) of the feeding pipe 10010 is connected to an open end of the crucible 10013. The crystal cooling mechanism 10011 is provided above the crucible 10013 by the lifting and lowering apparatus of the present invention. An upper furnace chamber 1001 is provided above the lower furnace chamber 10012, and a gate valve 1009 or a rotary plate valve is provided between the upper furnace chamber 1001 and the lower furnace chamber 10012. An upper shaft 1008 is provided in the middle of the top end of the upper furnace chamber, the upper shaft is a movement mechanism, the lower end head of the upper shaft 1008 is provided with an accommodating part, the accommodating part accommodates and connects the seed crystal 10018, and the upper shaft 1008 drives the seed crystal 10018 to move up and down. In use, when the heater 10014 heats the silicon material in the crucible 10013, the power source 10019 is activated. By using the elevator 1004 and the lifting and lowering arm 1007 to drive the crystal cooling mechanism 10011 to rise, the crystal cooling mechanism 10011 is separated from the crucible 10013. At this time, the heater 10014 heats the silicon material in the crucible 10013, so as to prevent the crystal cooling mechanism 10011 from absorbing heat during heating, thereby increasing the heating rate of the silicon material by the heater 10014. At the same time, the continuous feeding of the feeding pipe 10010 into the crucible 10013 can be better achieved by the upward movement of the crystal cooling mechanism 10011. When the silicon material in the crucible 10013 is melted, the seed crystal 10018 is lowered driven by the upper shaft 1008, and the crystal cooling mechanism 10011 is lowered to a predetermined position driven by the lifting and lowering apparatus. After the lower end head of the seed crystal 10018 contacts the molten silicon liquid and the lower end head of the seed crystal 10018 melts, the upper shaft 1008 drives the seed crystal 10018 to move upwards, and at this time, the silicon liquid rises simultaneously following the seed crystal 10018. After the silicon liquid rises to reach the crystal cooling mechanism 10011, the temperature of the silicon liquid gradually decreases and starts to crystallize, at which point the newly formed columnar crystal is the desired ingot 10017. The ingot 10017 can be either a large diameter single ingot or a small diameter silicon core. When the pulling is performed for a certain time, since the volatile in the silicon material adheres to the inner wall of the crystal cooling mechanism 10011, it is necessary to clean the adhered matter when the volatile adheres to a certain degree. When volatiles need to be cleaned, it is known to open the furnace chamber after stopping the furnace to clean the crystal cooling mechanism 10011. In the present invention, without stopping the furnace, the crystal cooling mechanism 10011 is lifted into the upper furnace chamber 1001 by the elevator 1004 and the lifting and lowering arm 1007, then the gate valve 1009 is closed to isolate the lower furnace chamber 10012 from the upper furnace chamber 1001, and then the furnace door on the upper furnace chamber 1001 is opened to clean the crystal cooling mechanism 10011. After cleaning, the furnace door is closed, a vacuum is applied to the upper furnace chamber 1001, then the gate valve 1009 is opened, and then the crystal cooling mechanism 10011 is lowered to the upper side of the crucible 10013 in the lower furnace chamber 10012 via the elevator 1004 and the lifting and lowering arm 1007 to start the pulling of the ingot 10017, which effectively improves the yield and pulling efficiency of the ingot 10017.

According to this embodiment, the present invention achieves the cleaning of volatiles attached to the cooling shield or crystal cooling mechanism without stopping the furnace by providing a valve between the upper furnace chamber and the lower furnace chamber, connecting the cooling shield or crystal cooling mechanism to the lifting and lowering apparatus, and moving the cooling shield or crystal cooling mechanism up and down within the cavities of the upper furnace chamber and the lower furnace chamber by the lifting and lowering apparatus. At the same time, it also avoids the absorption of the heat from the heater by the cooling shield or crystal cooling mechanism, etc. during heating, thereby reducing manual labor intensity and improving production efficiency.

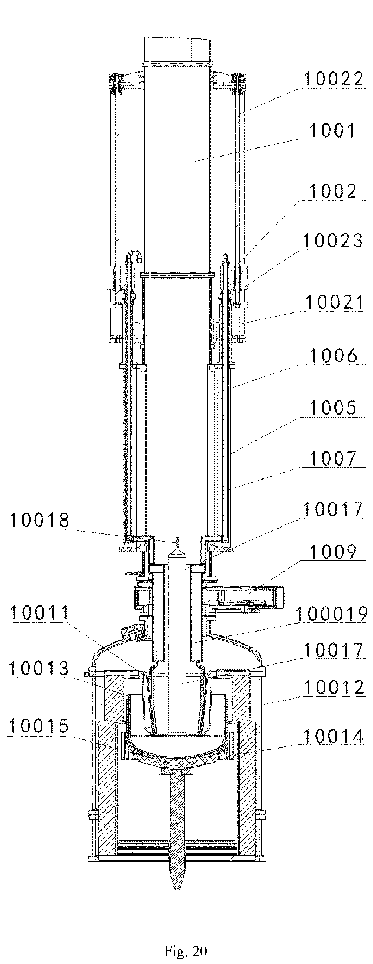

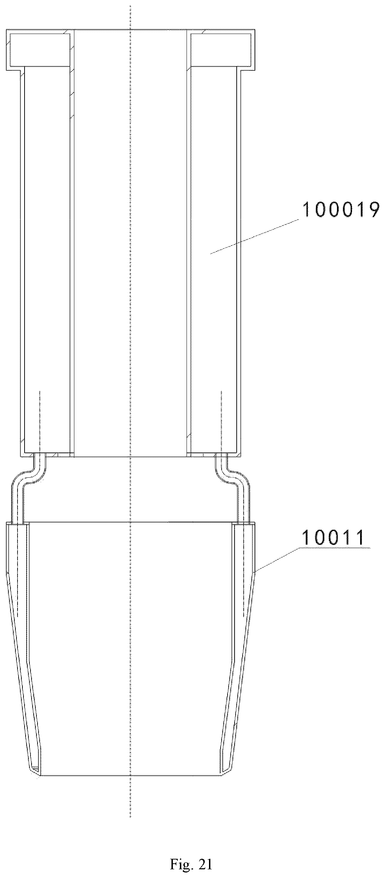

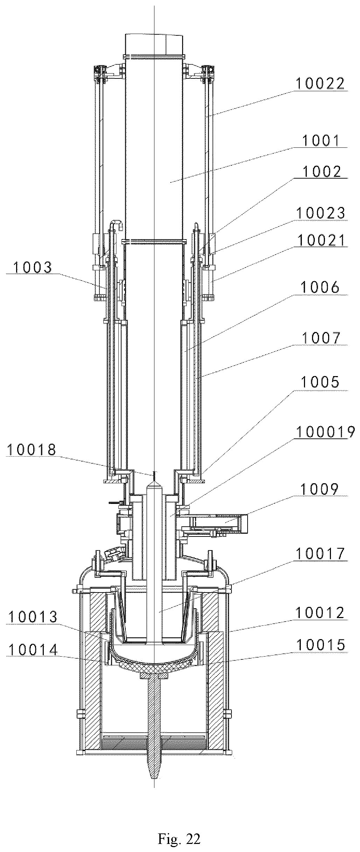

According to one preferred implementation solution of the present application, for example, the lifting and lowering apparatus described herein is used to pull a single ingot in a single crystal furnace, as shown in Figs. 20, 21, and 22. Here, the crystal cooling apparatus in Fig. 22 may be provided as a cooling jacket described below according to the second embodiment, the cooling jacket having one pulling hole in the middle thereof through which the pulled crystal passes. However, the structure of the cooling jacket is not limited thereto, and a plurality of crystal pulling holes may be provided on it.

The lifting and lowering arm 1007 is configured in a fold-line-shaped structure, and the lower end head of the lifting and lowering arm 1007 is connected to the crystal cooling mechanism 10011. Two linear grooves 1006 are formed on the outer edge face of the upper furnace chamber 1001 to penetrate through the inner wall of the upper furnace chamber. A cover body 1005 is provided on the outer edge face of the upper furnace chamber 1001 at the periphery of the linear groove 1006. The fold-line segment of the lifting and lowering arm 1007 moves up and down in the linear groove 1006 so that the lifting and lowering arm 1007 drives the cooling shield or cooling mechanism 10011 to move up and down in the upper furnace chamber 1001 and the lower furnace chamber 1002.

Further, the elevator 1004 includes a lifting and lowering block 1002, a power source 10019, a support frame 10020, a guide column 10021, a lead screw 10022, and a nut 10022. The support frame 10020 is provided on the outer side of the upper furnace chamber 1001. Two parallel guide columns 10021 are provided on the support frame 10020. Lifting and lowering blocks 1002 are provided on the two guide columns 10021. A nut 10023 is provided on the lifting and lowering block 1002. The nut 10023 is sleeved onto the lead screw 10022. The upper end and lower end of the lead screw 10022 are respectively provided at the upper end and lower end of the support frame 10020. The lead screw 10022 is connected to the power source 10019. The lifting and lowering block 1002 is connected to the lifting and lowering arm 1007 to drive the lifting and lowering arm 1007 to move up and down within the linear groove 1006.

When the present application is applied to single ingot pulling in a single crystal furnace, it has the following advantages.
1. After the silicon material in the crucible melts to form a silicon liquid, impurities in the silicon liquid and in the furnace chamber volatilize and float to the surface of the cooling shield or the cooling mechanism. Due to the cooling medium in the cooling shield, the temperature of the cooling shield is relatively low, in which case volatiles condense and adhere to the surface of the cooling shield. When the volatiles accumulate to a certain thickness, the same fall to the upper surface of the melt of the crucible and then float on the upper surface of the melt due to the turbulence of the gas flow and the effect of thermal expansion and contraction. Since the melting point of the volatiles is higher than the melting point of the silicon material, the volatiles cannot be melted, and further the volatiles cannot be vaporized, and the volatiles are continuously present on the upper surface of the molten liquid. As the crucible rotates at all times during the pulling, at the time the volatiles in the crucible will not be stationary at a certain point on the upper surface of the silicon melt, but will float at a variable position. Once the floater is attached to the crystal position of the ingot, the floater destroys the alignment direction of the molecules upon solidification of the silicon melt (dislocation occurring in the crystal direction), resulting in the fracture of the crystal line. At this time, the newly grown ingot is changed from a single crystal to a polycrystal, resulting in the failure of the growth of the single ingot.

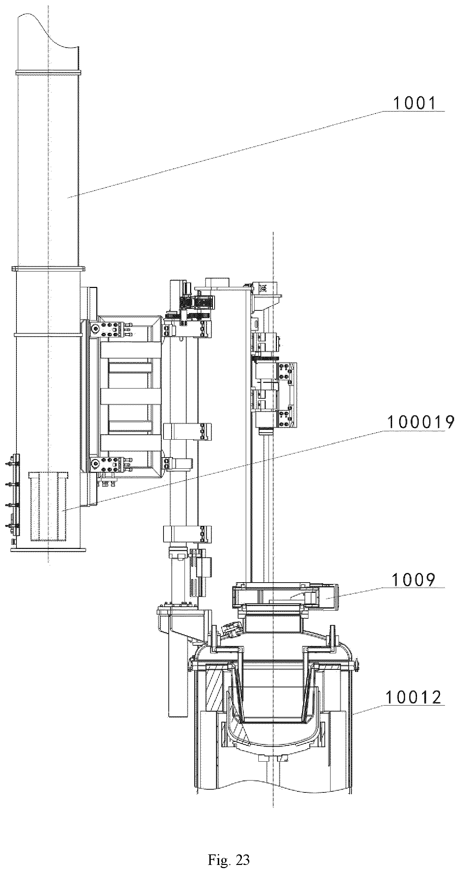

According to the present application, since a lifting and lowering apparatus for a cooling shield or a cooling mechanism is provided, when it is found that floats adhere to the cooling shield or cooling mechanism, the cooling shield or the cooling mechanism is lifted out of the lower furnace chamber by the lifting and lowering apparatus. When the cooling shield or cooling mechanism leaves the lower furnace chamber and enters the upper furnace chamber, the valve is closed. Then, the upper furnace chamber is rotated by the furnace chamber rotating mechanism so that the upper furnace chamber and the lower furnace chamber are disconnected (the state after the upper furnace chamber is rotated is as shown in Fig. 23; and the furnace chamber rotating mechanism is a conventional technique in the art, and many single crystal furnaces are using the same, and thus the description thereof will not be repeated herein). Therefore, in the case where the furnace is not stopped (the thermal field in the lower furnace chamber continues to work without stopping the furnace), the cooling shield or the cooling mechanism is cleaned to achieve continuous pulling of the ingot, and the problem that the cooling shield cannot be cleaned is effectively avoided.

2. When water leakage occurs in the cooling shield or the cooling mechanism during pulling, the cooling shield or the cooling mechanism can be lifted out of the lower furnace chamber by means of the lifting and lowering apparatus. When the cooling shield leaves the lower furnace chamber and enters the upper furnace chamber, the valve is closed. Then, the upper furnace chamber is rotated by the furnace chamber rotating mechanism to disconnect the upper furnace chamber from the lower furnace chamber (the furnace chamber rotating mechanism is a conventional technique in the art, and many single crystal furnaces use the same), and a new cooling shield is replaced without stopping the furnace (the thermal field in the lower furnace chamber continues to work without stopping the furnace). Therefore, the problem that the cooling water is instantaneously vaporized at a high temperature in the thermal field when water leakage occurs in the cooling shield, the possibility of explosion of the furnace body, and the like are effectively avoided.

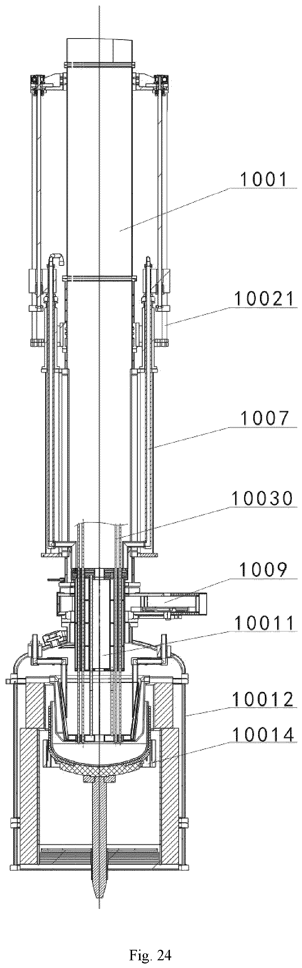

According to another preferred implementation solution of the present application, for example, the lifting and lowering apparatus described in the present application is applied to a silicon core furnace for simultaneously pulling a plurality of silicon cores using the Czochralski method to simultaneously pull a plurality of silicon cores, as shown in Fig. 24.

The lifting and lowering arm 1007 is configured to have a fold-line-shaped structure. The lifting and lowering arm 1007 is connected to a cooling shield or a cooling mechanism 10011. Two linear grooves 1006 are formed on the outer edge face of the upper furnace chamber 1001 to penetrate through the inner wall of the upper furnace chamber. A cover body 1005 is provided on the outer edge face of the upper furnace chamber 1001 at the periphery of the linear groove 1006. The fold-line segment of the lifting and lowering arm 1007 moves up and down in the linear groove 1006 so that the lifting and lowering arm 1007 drives the cooling shield or cooling mechanism 10011 to move up and down in the upper furnace chamber 1001 and the lower furnace chamber 1002.

Further, the elevator 1004 includes a lifting and lowering block 1002, a power source 10019, a support frame 10020, a guide column 10021, a lead screw 10022, and a nut 10022. The support frame 10020 is provided on the outer side of the upper furnace chamber 1001. Two parallel guide columns 10021 are provided on the support frame 10020, lifting and lowering blocks 1002 are provided on the two guide columns 10021, and a nut 10023 is provided on the lifting and lowering block 1002. The nut 10023 is sleeved onto the lead screw 10022. The upper end and lower end of the lead screw 10022 are respectively provided at the upper end and lower end of the support frame 10020. The lead screw 10022 is connected to the power source 10019. The lifting and lowering block 1002 is connected to the lifting and lowering arm 1007 to drive the lifting and lowering arm 1007 to move up and down within the linear groove 1006.

When the present application is applied to a silicon core furnace to simultaneously pull a plurality of silicon cores, it has the following advantages.
1. After the silicon material in the crucible melts to form a silicon liquid, impurities in the silicon liquid and in the furnace chamber volatilize and float to the surface of the crystal cooling mechanism 10011. Due to the cooling medium in the crystal cooling mechanism 10011, the temperature of the crystal cooling mechanism 10011 is relatively low, in which case volatiles condense and adhere to the surface of the crystal cooling mechanism 10011. When the volatiles accumulate to a certain thickness, the same fall to the upper surface of the melt of the crucible and then float on the upper surface of the melt due to the turbulence of the gas flow and the effect of thermal expansion and contraction. Since the melting point of the volatiles is higher than the melting point of the silicon material, the volatiles cannot be melted, and further the volatiles cannot be vaporized, and the volatiles are continuously present on the upper surface of the molten liquid. As the crucible rotates at all times during the pulling, at the time the volatiles in the crucible will not be stationary at a certain point on the upper surface of the silicon melt, but will float at a variable position. Once the floater is attached to the crystallization position of the silicon core, the light one causes the convex deformation of the outer edge face of the pulled silicon core. In severe cases, the silicon core is stuck in the crystal perforation due to the change in the diameter of the silicon core, and is finally forced to stop, thus ending the pulling of this round. The pulled silicon core cannot be used as a finished product and can only be scrapped.

According to the present application, since a lifting and lowering apparatus for a cooling shield or a cooling mechanism is provided, when it is found that a float adheres to the crystal cooling mechanism 10011, the crystal cooling mechanism 10011 can be lifted out of the lower furnace chamber by the lifting and lowering apparatus. When the crystal cooling mechanism 10011 leaves the lower furnace chamber and enters the upper furnace chamber, the valve is closed. Then the upper furnace chamber is rotated by the furnace chamber rotating mechanism so that the upper furnace chamber and the lower furnace chamber are disconnected. Therefore, in the case of not stopping the furnace (the thermal field in the lower furnace chamber continues to work without stopping the furnace), the crystal cooling mechanism 10011 is cleaned to achieve continuous pulling of the ingot (namely, the crystal cooling mechanism is lifted into the upper furnace chamber 1001 above the valve by the lifting and lowering apparatus; and the lower furnace chamber below the valve is still in continuous operation so that the crystal cooling mechanism can be cleaned without stopping the furnace). Therefore, the inability to clean the crystal cooling mechanism 10011 is effectively avoided.

2. Through the arrangement of a lifting and lowering apparatus, the crystal cooling mechanism can be lifted out of the lower furnace chamber, so as to provide a feeding channel for the continuous feeding apparatus when the crucible achieves continuous feeding, thereby achieving the working condition requirements for continuous feeding of the crucible under the state of not stopping the furnace.

3. Since it is possible to realize the cleaning of the adhesive substances on the crystal cooling mechanism without stopping the furnace, the production efficiency, etc. of the silicon core is effectively improved.

### Second Embodiment

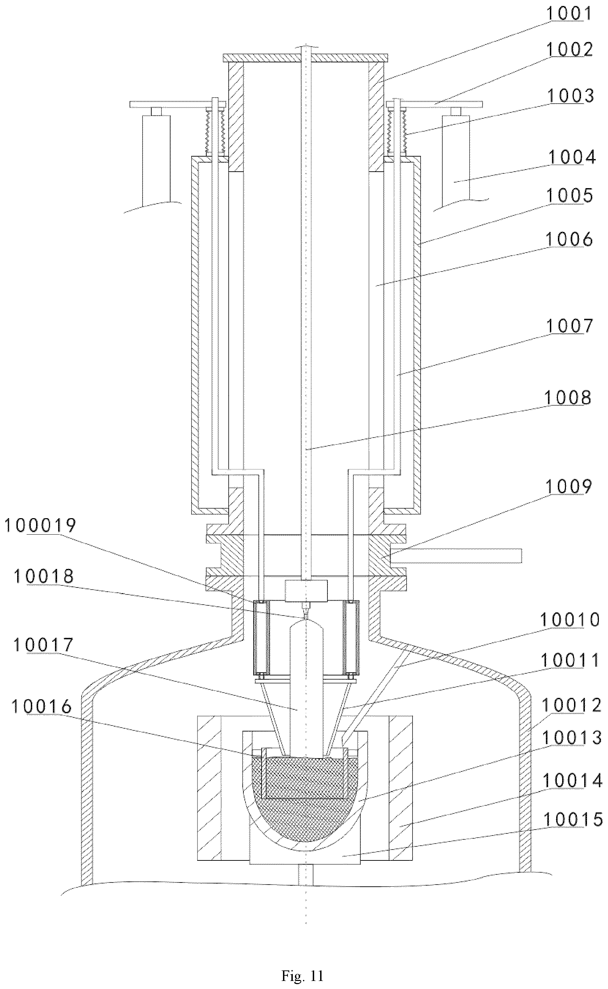

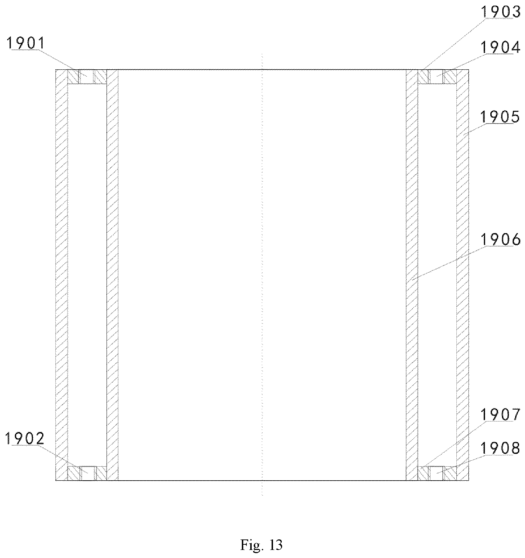

Figs. 11 to 12 show the second embodiment according to the present application. As shown, the second embodiment differs from the first embodiment in that: a cooling jacket 100019 is provided in connection between the cooling apparatus or cooling shield and the lifting and lowering apparatus. Figs. 13 to 19 show several different structures of the cooling jacket 100019 according to preferred embodiments of the present application. However, the structures of the cooling jacket are not limited thereto, and the cooling jacket of the present application may be modified or replaced as necessary.

An artificial crystal furnace having a lifting and lowering function for crystal pulling will be described with reference to Figs. 11 to 24.

As shown, the artificial crystal furnace includes an upper furnace chamber 1001, an elevator 1004, a lifting and lowering arm 1007, a crystal cooling mechanism 10011, a cooling jacket 100019, and a valve. The upper furnace chamber 1001 is provided above the lower furnace chamber 10012, and a valve is provided between a lower end face of the upper furnace chamber 1001 and an upper end face of the lower furnace chamber 10012. In practice, the main function of the valve is to divide the cavities of the upper furnace chamber 1001 and the lower furnace chamber 10012 into two independent cavities. That is, when the valve is opened, the cavities of the upper furnace chamber 1001 and the lower furnace chamber 10012 communicate to form one integral cavity; and when the valve is closed, the cavities of the upper furnace chamber 1001 and lower furnace chamber 10012 are divided into two independent cavities. The valve is a gate valve 1009. In addition, a furnace door that can be opened and closed is provided on the outer edge face of the upper furnace chamber 1001 through a hinge.

Further, at least one lifting and lowering arm 1007 is provided in the upper furnace chamber 1001, and the lower end of the lifting and lowering arm 1007 is connected to the upper end of the cooling jacket 100019. The lower end of the cooling jacket 100019 is connected to the crystal cooling mechanism 10011, and the lifting and lowering arm 1007 drives the cooling jacket 100019 and the crystal cooling mechanism 10011 to move up and down in the cavities of the upper furnace chamber 1001 and the lower furnace chamber 10012. That is to say, the scenario can be achieved that the lifting and lowering arm 1007 drives the cooling jacket 100019 and the crystal cooling mechanism 10011 to move up into the upper furnace chamber 1001 and completely disengage from the lower furnace chamber 10012.

Further, the cooling medium channel on the lifting and lowering arm 1007 is in series or parallel communication with the cooling jacket 100019 and the crystal cooling mechanism 10011. In an implementation, the side wall of the lifting and lowering arm 1007 is provided with a cooling medium channel; or the lifting and lowering arm 1007 is provided with a hollow structure, and the inner hole in the middle of the lifting and lowering arm 1007 is provided with a cooling medium channel. That is, the cooling medium introduced in the cooling jacket 100019 and the crystal cooling mechanism 10011 is transferred through the cooling medium channel on the lifting and lowering arm 1007.

When one lifting and lowering arm 1007 is provided, two cooling medium channels for letting in and out are provided on the lifting and lowering arm 1007. An upper port of one of the cooling medium channels is connected to a cooling source, and a lower port is connected to an upper inlet for the cooling medium 1901on the cooling jacket 100019. A lower port of the other cooling medium channel is connected to an upper outlet for the cooling medium 1904 on the cooling jacket 100019, and an upper port is connected to a recovery port of the cooling source. The cooling jacket 100019 and the crystal cooling mechanism 10011 communicate in series or in parallel, i.e. two cooling medium channels, one in and one out, form one complete medium flowing channel with the cooling jacket 100019 and the crystal cooling mechanism 10011.

When two lifting and lowering arms 1007 are provided, one cooling medium channel is provided on two lifting and lowering arms 1007 respectively, and the two cooling medium channels are one in and one out, also forming one complete medium flowing channel. The structure of the crystal cooling mechanism 10011 in the present embodiment is substantially the same as that in the first embodiment, and therefore will not be described in detail herein.

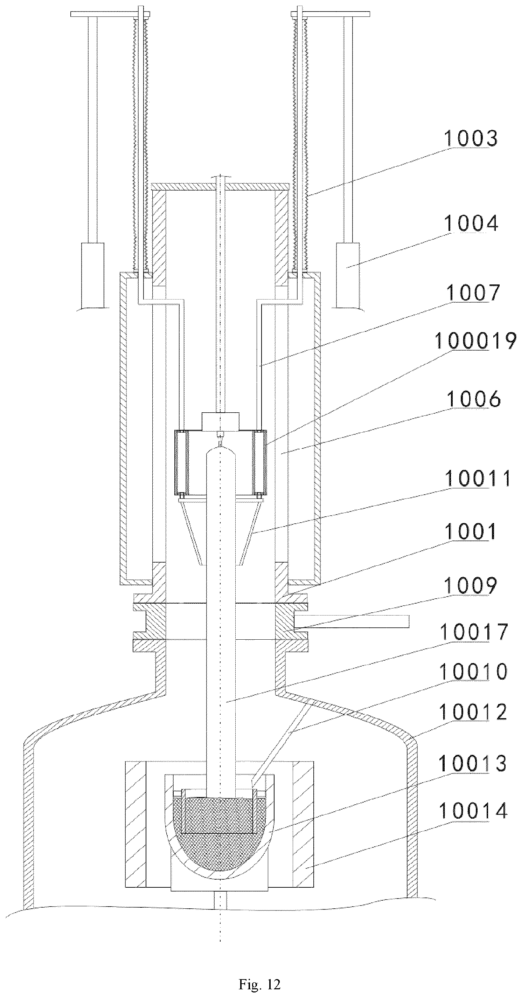

In an implementation, as shown in Figs. 11 and 12, when two lifting and lowering arms 1007 are provided, the two lifting and lowering arms 1007 are symmetrically provided in the upper furnace chamber 1001. The connection forms of the lifting and lowering arm 1007 and the cooling jacket 100019 are various, and are conventional connection forms in the art, such as a threaded connection or a welded connection, etc.; however, it needs to be ensured that no medium leakage occurs after the connection, and the tightness of the connection needs to be ensured. In a specific implementation, the number of the lifting and lowering arms 1007 is preferably two, and the two lifting and lowering arms 1007 are symmetrically provided, so that it can be ensured that the cooling jacket 100019 and the crystal cooling mechanism 10011 can be lifted and lowered smoothly and the economic efficiency and the practicability are optimal. Three or more lifting and lowering arms can also be used, which is also within the scope of protection of the present application. When one lifting and lowering arm 1007 is provided, the lifting and lowering of the lifting and lowering arm 1007 can also be realized, which is also within the scope of the present application.

In an implementation, when the cooling medium channel is in serial communication with the cooling jacket 100019 and the crystal cooling mechanism 10011, the upper ends of the cooling medium channel are respectively connected to the cooling source and the cooling medium recovery apparatus, the outlet at the lower end of the cooling medium channel is connected to the upper inlet for the cooling medium 1901 on the cooling jacket 100019, the inlet at the lower end of the cooling medium channel is connected to the upper outlet for the cooling medium 1904 on the cooling jacket 100019, the lower outlet for the cooling medium 1902 on the cooling jacket 100019 is connected to the cooling medium inlet on the crystal cooling mechanism 10011, and the cooling medium outlet on the crystal cooling mechanism 10011 is connected to the lower inlet for the cooling medium 1908 on the cooling jacket 100019. If the cooling medium channel is in parallel communication with the cooling jacket 100019 and the crystal cooling mechanism 10011, the upper ends of the cooling medium channel are respectively connected to the cooling source and the cooling medium recovery apparatus; the outlets at the lower end of the cooling medium channel are respectively connected to the upper inlet for the cooling medium 1901 on the cooling jacket 100019 and the cooling medium inlet on the crystal cooling mechanism 10011 via pipes; and the inlets at the lower end of the cooling medium channel are respectively connected to the upper outlet for the cooling medium 1904 on the cooling jacket 100019 and the cooling medium outlet on the crystal cooling mechanism 10011 via pipes.

Further, an upper end head of the lifting and lowering arm 1007 passes through the upper furnace chamber 1001 and is connected to an elevator 1004 provided outside the upper furnace chamber 1001, and the lifting and lowering arm 1007 is driven to move up and down by the elevator 1004. The main function of the elevator 1004 is to drive the lifting and lowering arm to move up and down, and a sealing body is provided between the outer edge faces of the upper furnace chamber 1001 and the lifting and lowering arm 1007, thereby forming the crystal cooling apparatus with a lifting and lowering function for crystal pulling.

Further, at least one linear groove 1006 penetrating through the inner wall of the upper furnace chamber 1001 is provided on the outer edge face of the upper furnace chamber 1001. A cover body 1005 is provided on the outer edge face of the upper furnace chamber 1001 at the periphery of the linear groove 1006. The fold-line-shaped structure of the lifting and lowering arm 1007 moves up and down in the linear groove 1006, and an upper part of the lifting and lowering arm 1007 passes through an upper end face of the cover body 1005 to be connected to the elevator 1004 provided outside the cover body 1005.

In a specific implementation, the lifting and lowering arm 1007 is configured in a linear structure or a fold-line-shaped structure.

When the lifting and lowering arm 1007 is provided as a fold-line-shaped structure, it can be seen from Figs. 11 to 12 that the main function of the fold-line-shaped structure is to enable the connection of the elevator 1004, the cooling jacket 100019, and the crystal cooling mechanism 10011 which are not on the same straight line. In practical applications, the fold-line-shaped structure referred to, whether it is a straight-line bend or an arc bend or a diagonal bend, is within the scope of the present application. At least one linear groove 1006 penetrating through the inner wall of the upper furnace chamber 1001 is provided on the outer edge face of the upper furnace chamber 1001. In an implementation, the number of linear grooves 1006 is preferably two, and the two linear grooves 1006 are preferably symmetrically provided. A cover body 1005 is provided on the outer edge face of the upper furnace chamber 1001 at the periphery of the linear groove 1006. The fold-line-shaped structure of the lifting and lowering arm 1007 moves up and down in the linear groove 1006. An upper part of the lifting and lowering arm 1007 passes through an upper end face of the cover body 1005 to be connected to the elevator 1004 provided outside the cover body 1005. In an implementation, the cover body 1005 may be welded to the outer edge face of the upper furnace chamber 1001 so that the inner cavity of the cover body 1005 and the inner cavity of the upper furnace chamber 1001 form one integral cavity through the linear groove 1006. A lifting and lowering arm perforation for accommodating the lifting and lowering arm 1007 to move up and down is provided on the upper end face of the cover body 1005. A sealing body is provided in the lifting and lowering arm perforation, and the main function of the sealing body is to ensure that the integral cavity formed by the upper furnace chamber 1001 and the cover body 1005 is one sealed cavity, that is to say, to ensure that when the lifting and lowering arm 1007 moves up and down, no leakage occurs in the sealed cavity. The sealing body may be selected from a sealing ring or an O-shaped ring or a shaft seal, etc. as long as the sealing effect is achieved.

Similar to the first embodiment, in a specific implementation, at least one lifting and lowering arm cavity may alternatively be provided on the outer edge face of the upper furnace chamber 1001. The lifting and lowering arm cavity is of an annular structure or a linear structure, and the inner cavity of the lifting and lowering arm cavity and the inner cavity of the upper furnace chamber 1001 are provided integral to form one integral cavity. An elevator 1004 is provided above the lifting and lowering arm cavity, and the elevator 1004 is connected to the upper end head of the lifting and lowering arm 1007. That is, the main function of the lifting and lowering arm cavity is to form one space for the lifting and lowering arm 1007 to move up and down, and its specific structural form may be provided as an annular structure, or any other various shapes may be selected as long as it can ensure that the lifting and lowering arm 1007 moves up and down in the upper furnace chamber 1001. Also, this effect can be achieved by increasing the diameter of the upper furnace chamber 1001 as a whole. Increasing the diameter of the upper furnace chamber 1001 as a whole may result in slightly lower economic efficiency, but this structure is also within the scope of protection of the present application.

Further, when the lifting and lowering arm 1007 is provided in a linear structure, the upper portion of the lifting and lowering arm 1007 is connected to the elevator 1004 provided at the top of the upper furnace chamber 1001 through the top of the upper furnace chamber 1001. It should be understood that in this form of structure, the lifting and lowering arm 1007 may also be provided in a fold-line-shaped structure.

Further, the elevator 1004 is any one of a hydraulic cylinder or an air cylinder or an electric push rod or a lead screw elevator or an elevator for flexible shaft. In an implementation, when the elevator 1004 is provided as a hydraulic cylinder or air cylinder or an electric push rod, it may be directly connected to the upper end of the lifting and lowering arm 1007. At this time, the up-and-down movement of the lifting and lowering arm 1007 can be achieved by simply providing the hydraulic cylinder or the air cylinder or the electric push rod above the upper furnace chamber, providing the hydraulic cylinder or the air cylinder or the electric push rod on one bracket, and connecting the telescopic rod of the hydraulic cylinder or the air cylinder or the electric push rod to the upper end of the lifting and lowering arm 1007. When the hydraulic cylinder or air cylinder or electric push rod is provided on the upper furnace chamber 1001 or a support frame of the rack, the telescopic rod on the hydraulic cylinder or the air cylinder or the electric push rod is connected to the lifting and lowering block 1002, and the lifting and lowering block 1002 is connected to the upper end head of the lifting and lowering arm 1007, so that the lifting and lowering arm 1007 moves up and down.

Further, the lead screw elevator comprises a lifting and lowering block 1002, a power source, a support frame, a guide column, a lead screw, and a nut. The support frame is provided on the outer side of the upper furnace chamber 1001. For example, it can be provided on the bracket of the rack or directly on the rack. Two parallel guide columns are provided on the support frame, a lifting and lowering block 1002 is provided on the two guide columns, a nut is provided on the lifting and lowering block 1002, and the nut is sleeved on the lead screw. The upper end and lower end of the lead screw are respectively provided at the upper end and lower end of the support frame, and the upper end head or the lower end head of the lead screw is connected to the power source. The power source is preferably a motor. It is also possible to transition between the motor and the lead screw through a reducer. The lifting and lowering block 1002 is connected to the upper end head of the lifting and lowering arm 1007. In an implementation, alternative structures of the guide columns may be linear guide rails. The lifting and lowering block 1002 has a rectangular structure. Two guide holes for mounting the guide columns are provided on the upper face of the lifting and lowering block 1002, and a nut fixing hole is provided in the middle of the lifting and lowering block 1002. A nut is provided in the nut fixing hole, and a lifting and lowering arm fixing hole is provided at the front end of the nut fixing hole. The lifting and lowering arm fixing hole is connected to the lifting and lowering arm 1007.

Further, the elevator for flexible shaft includes a lifting and lowering block 1002, a power source, a support frame, a guide column, an elevator for flexible shaft, and a flexible shaft. The support frame is provided on the outer side of the upper furnace chamber 1001, two parallel guide columns are provided on the support frame, and a lifting and lowering block 1002 is provided on the two guide columns. A flexible shaft is installed on the lifting and lowering block 1002 between the two guide columns. The upper end head of the flexible shaft is connected to an elevator for flexible shaft provided above the support frame. The elevator for flexible shaft is externally connected to a power source. The lifting and lowering block 1002 is connected to the upper end head of the lifting and lowering arm 1007. In an implementation, alternative structures of the guide columns may be chosen to be linear guide rail likewise. The elevator for flexible shaft is also directly available in the market by purchasing, and its structure includes a housing, a flexible shaft roller, a ball spline, and a nut, etc. One flexible shaft roller is placed in the housing, and the flexible shaft roller is sleeved on the ball spline, and the ball spline is driven by the power source to realize forward rotation or reverse rotation. An external thread is provided on one end of the flexible shaft roller, the external thread cooperates with a nut, and the nut is fixed in the housing. The flexible shaft is wound on the flexible shaft roller. During winding, the flexible shaft roller makes a left-right movement while making a rotation movement on the ball spline, so as to ensure that the lower end head of the flexible shaft does not make a left-right movement, but only makes an up-down movement.

Further, in order to improve the sealing performance of the upper furnace chamber 1001, a bellows 1003 is sleeved on the outer edge face of the lifting and lowering arm 1007. The upper end of the bellows 1003 is connected to the lifting and lowering block 1002 in the elevator 1004, and the lower end of the bellows 1003 is connected to the upper furnace chamber 1001.

In a specific implementation of the present application, taking the pulling of a silicon material as an example, as shown in Figs. 11 and 12, a crucible support seat 10015 is provided in the lower furnace chamber 10012, and a crucible 10013 is provided on the crucible support seat 10015. An isolating sleeve 10016 is provided inside the crucible 10013, and a heater 10014 is provided at the periphery of the crucible 10013. The lower furnace chamber 10012 is provided with a feeding pipe 10010. One end (e.g. the upper end in the figure) of the feeding pipe 10010 is connected to an automatic feeding apparatus, and the other end (e.g. the lower end in the figure) of the feeding pipe 10010 is connected to the open end of the crucible 10013. The crystal cooling mechanism 10011 is provided above the crucible 10013 by the lifting and lowering apparatus of the present application. An upper furnace chamber 1001 is provided above the lower furnace chamber 10012, and a gate valve 1009 is provided between the upper furnace chamber 1001 and the lower furnace chamber 10012. An upper shaft 1008 is provided at the middle of the top end of the upper furnace chamber. The lower end of the upper shaft 1008 is connected to a seed crystal 10018, and the upper shaft 1008 drives the seed crystal 10018 to move up and down. In use, when the heater 10014 heats the silicon material in the crucible 10013, a power source is started at this moment. The cooling jacket 100019 and the crystal cooling mechanism 10011 are driven to rise via the elevator 1004 and the lifting and lowering arm 1007, so that the cooling jacket 100019 and the crystal cooling mechanism 10011 are separated from the crucible 10013. After the cooling jacket 100019 and the crystal cooling mechanism 10011 are separated from the crucible 10013, the heater 10014 heats the silicon material in the crucible 10013, so as to prevent the cooling jacket 100019 and the crystal cooling mechanism 10011 from absorbing heat during heating, thereby increasing the heating rate of the silicon material by the heater 10014. At the same time, the continuous feeding of the feeding pipe 10010 into the crucible 10013 can be better achieved by the upward movement of the cooling jacket 100019 and the crystal cooling mechanism 10011. When the silicon material in the crucible 10013 is melted, the seed crystal 10018 is lowered driven by the upper shaft 1008, and the crystal cooling mechanism 10011 is lowered to a predetermined position driven by the lifting and lowering apparatus. After the lower end head of the seed crystal 10018 contacts the molten silicon liquid and the lower end head of the seed crystal 10018 melts, the upper shaft 1008 drives the seed crystal 10018 to move upwards, and at this time, the silicon liquid rises simultaneously following the seed crystal 10018. After the silicon liquid rises to reach the crystal cooling mechanism 10011, the temperature of the silicon liquid gradually decreases and starts to crystallize. The cooling jacket 100019 then further cools the pulled ingot 10017, and the newly formed columnar crystal is the desired ingot 10017. The ingot 10017 can be either a large diameter single ingot or a small diameter silicon core. When the pulling is performed for a certain time, since the volatile in the silicon material adheres to the inner wall of the crystal cooling mechanism 10011, it is necessary to clean the adhered matter when the volatile adheres to a certain degree. When volatiles need to be cleaned, it is known to open the furnace chamber after stopping the furnace to clean the cooling jacket 100019 and the crystal cooling mechanism 10011. In the present application, without stopping the furnace, the cooling jacket 100019 and the crystal cooling mechanism 10011 are lifted into the upper furnace chamber 1001 by the elevator 1004 and the lifting and lowering arm 1007, then the gate valve 1009 is closed to isolate the lower furnace chamber 10012 from the upper furnace chamber 1001, and then the furnace door on the upper furnace chamber 1001 is opened to clean the cooling jacket 100019 and the crystal cooling mechanism 10011. After cleaning, the furnace door is closed, the upper furnace chamber 1001 is vacuumized, and then the gate valve 1009 is opened; and the cooling jacket 100019 and the crystal cooling mechanism 10011 are lowered into the lower furnace chamber 10012 via the elevator 1004 and the lifting and lowering arm 1007 and suspended above the crucible 10013, and then the pulling of the ingot 10017 is started. This effectively improves the yield, pulling efficiency, etc. of the ingot 10017.

The lifting and lowering mechanism referred to in this embodiment may use the lifting and lowering apparatus described in the first embodiment.

Further, when the cooling medium channel is in series communication with the cooling jacket 100019 and the crystal cooling mechanism 10011, the structure of the cooling jacket 100019 is as shown in Fig. 13. A first structure of the cooling jacket 100019 is that the cooling jacket 100019 includes an upper cover plate 1903, a cooling jacket outer ring 1905, a cooling jacket inner ring 1906, and a lower cover plate 1907. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the upper cover plate 1903, and a lower outlet for the cooling medium 1902 and a lower inlet for the cooling medium 1908 are symmetrically provided on the lower cover plate 1907.

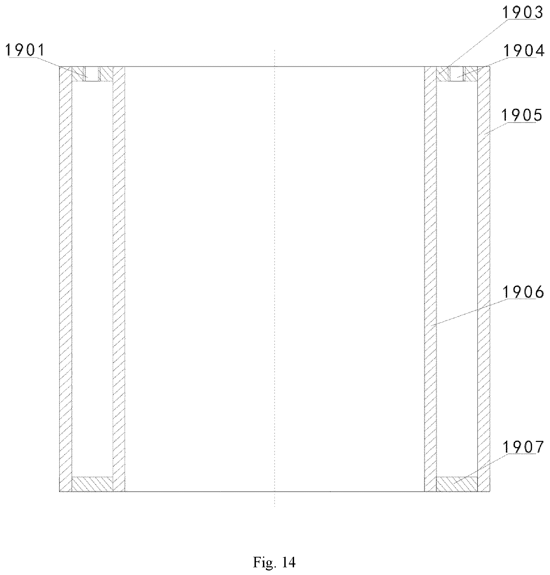

Further, when the cooling medium channel is in parallel communication with the cooling jacket 100019 and the crystal cooling mechanism 10011, the structure of the cooling jacket 100019 is as shown in Fig. 14. A second structure of the cooling jacket 100019 is that the cooling jacket 100019 includes an upper cover plate 1903, a cooling jacket outer ring 1905, a cooling jacket inner ring 1906, and a lower cover plate 1907. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the upper cover plate 1903.

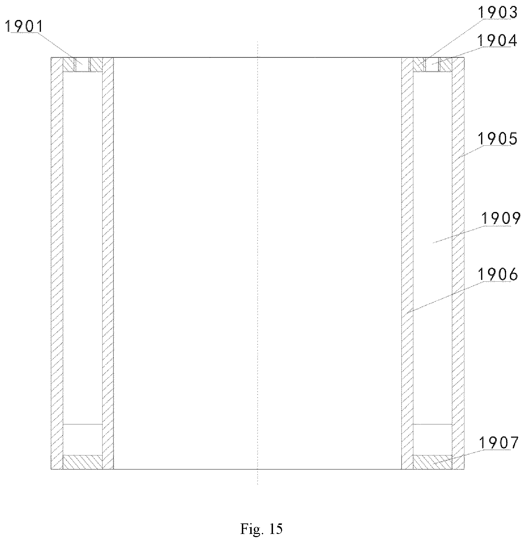

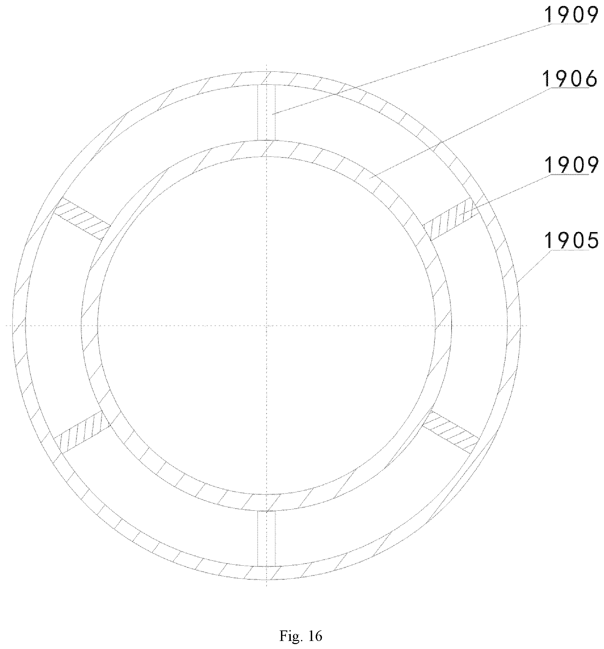

Further, when the cooling medium channel is in parallel communication with the cooling jacket 100019 and the crystal cooling mechanism 10011, the structure of the cooling jacket 100019 can also be as shown in Figs. 15 to 16. A third structure of the cooling jacket 100019 is that the cooling jacket 100019 includes an upper cover plate 1903, a cooling jacket outer ring 1905, a cooling jacket inner ring 1906, a lower cover plate 1907, and a flow guide plate 1909. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the upper cover plate 1903. A plurality of flow guide plates 1909 are spaced within the cavity between the cooling jacket outer ring 1905 and the cooling jacket inner ring 1906. The plurality of flow guide plates 1909 is provided in the form of flow guide plates 1909 whose upper end heads are in contact with the upper cover plate 1903 in cavities at positions before and after the upper inlet for the cooling medium 1901 and the upper outlet for the cooling medium 1904, respectively. In order to further improve the cooling effect, as shown in Fig. 16, one flow guide plate 1909 whose lower end head is connected to the lower cover plate 1907 is respectively provided between two flow guide plates 1909 whose upper end heads are in contact with the upper cover plate 1903. This makes it possible to achieve a wave-shaped flow of the cooling medium in the cavity, further improving the cooling effect and the like.

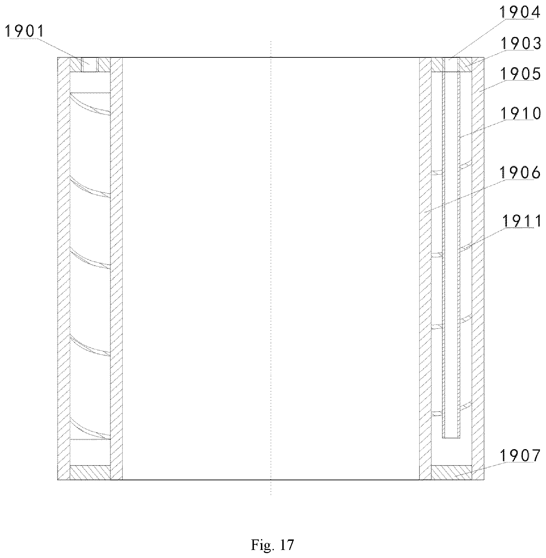

Further, when the cooling medium channel is in parallel communication with the cooling jacket 100019 and the crystal cooling mechanism 10011, the structure of the cooling jacket 100019 can also be as shown in Fig. 17. A fourth structure of the cooling jacket 100019 is that the cooling jacket 100019 includes an upper cover plate 1903, a cooling jacket outer ring 1905, a cooling jacket inner ring 1906, a lower cover plate 1907, a cooling medium return pipe 1910, and a spiral flow guide plate 1911. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the upper cover plate 1903. A spiral flow guide plate 1911 is provided in the cavity between the cooling jacket outer ring 1905 and the cooling jacket inner ring 1906. The upper outlet for the cooling medium 1904 is connected to an upper end head of the cooling medium return pipe 1910 provided in a cavity between the cooling jacket outer ring 1905 and the cooling jacket inner ring 1906, the cooling medium return pipe 1910 passes through the spiral flow guide plate 1911, and its lower end head is located at a middle lower portion of the cavity between the cooling jacket outer ring 1905 and the cooling jacket inner ring 1906.

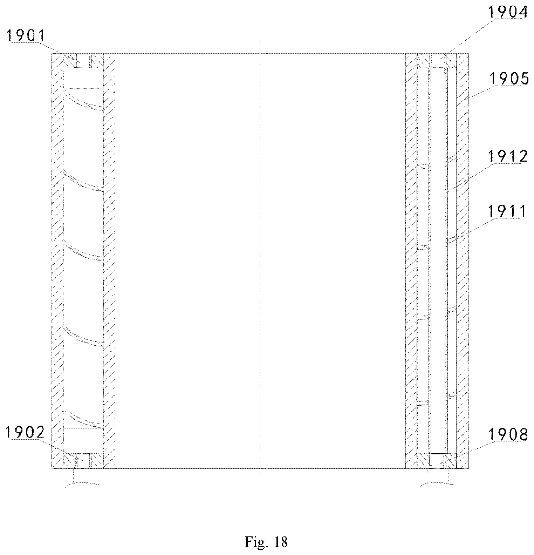

Further, when the cooling medium channel is in series communication with the cooling jacket 100019 and the crystal cooling mechanism 10011, the structure of the cooling jacket 100019 can also be as shown in Fig. 18. A fifth structure of the cooling jacket 100019 is that the cooling jacket 100019 comprises an upper cover plate 1903, a cooling jacket outer ring 1905, a cooling jacket inner ring 1906, a lower cover plate 1907, a spiral flow guide plate 1911, and a cooling medium guide pipe 1912. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the upper cover plate 1903, and a lower outlet for the cooling medium 1902 and a lower inlet for the cooling medium 1908 are symmetrically provided on the lower cover plate 1907. A spiral flow guide plate 1911 is provided in the cavity between the cooling jacket outer ring 1905 and the cooling jacket inner ring 1906. The upper outlet for the cooling medium 1904 is connected to an upper end head of the cooling medium flow guide pipe 1912 provided in a cavity between the cooling jacket outer ring 1905 and the cooling jacket inner ring 1906, and the cooling medium flow guide pipe 1912 passes through the spiral flow guide plate 1911 and its lower end head is connected to the lower inlet for the cooling medium 1908.

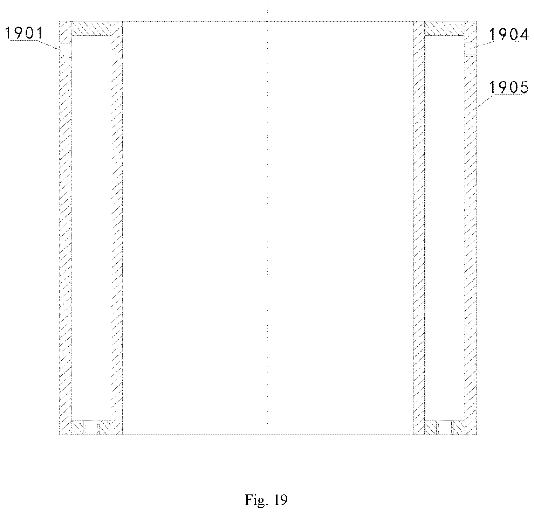

Further, when the cooling medium channel is in series communication with the cooling jacket 100019 and the crystal cooling mechanism 10011, the structure of the cooling jacket 100019 can also be as shown in Fig. 19. A sixth structure of the cooling jacket 100019 is that the cooling jacket 100019 includes an upper cover plate 1903, a cooling jacket outer ring 1905, a cooling jacket inner ring 1906, and a lower cover plate 1907. The cooling jacket outer ring 1905 is sleeved around the cooling jacket inner ring 1906. The upper cover plate 1903 is provided at the upper end of the cavity between the cooling jacket outer ring 1905 and the cooling jacket inner ring 1906, and the lower cover plate 1907 is provided at the lower end of the cavity between the cooling jacket outer ring 1905 and the cooling jacket inner ring 1906. An upper inlet for the cooling medium 1901 and an upper outlet for the cooling medium 1904 are symmetrically provided on the outer edge face of the cooling jacket outer ring 1905, and a lower outlet for the cooling medium 1902 and a lower inlet for the cooling medium 1908 are symmetrically provided on the lower cover plate 1907.

In this embodiment, a cooling jacket is provided above the cooling shield or the cooling apparatus, and the ingot is cooled by the cooling jacket and the cooling shield or the cooling apparatus, so that the cooling rate of the ingot is increased, thereby improving the pulling efficiency of the ingot. In addition, by providing a valve between the upper furnace chamber and the lower furnace chamber, connecting the cooling jacket and the cooling shield to the lifting and lowering arm, connecting the lifting and lowering arm to the elevator, and driving the cooling jacket and the cooling shield to move up and down in the cavities of the upper furnace chamber and the lower furnace chamber by the lifting and lowering arm, it achieves the cleaning of volatile substances attached to the cooling jacket and cooling shield without stopping the furnace, while also avoiding the absorption of heat from a heater by the cooling jacket and cooling shield or cooling apparatus during heating, etc. Therefore, the labor intensity is reduced and the production efficiency is improved, and other advantages, making it suitable for large-scale promotion and application.

The foregoing descriptions are only preferred embodiments of the invention, and are not intended to limit the invention. For those skilled in the art, the above embodiments of the present invention can be combined with each other, and the invention can have various modifications and changes. Any modification, equivalent replacement, improvement, etc. made within the spirit and principle of the invention shall be included in the protection scope of the invention.

## Claims

1. An artificial crystal furnace, **characterized by** comprising:
a furnace body, the furnace body comprising an upper furnace chamber (1001), a lower furnace chamber (10012) provided below the upper furnace chamber (1001), and a valve provided between the upper furnace chamber (1001) and the lower furnace chamber (10012), the valve being capable of dividing the upper furnace chamber (1001) and the lower furnace chamber (10012) into two independent cavities;
a crystal cooling mechanism (10011), provided in the furnace body and provided with at least one pulling hole for a pulled crystal to pass through; and
a lifting and lowering apparatus, provided at the upper furnace chamber (1001), connected to the crystal cooling mechanism (10011), and driving the crystal cooling mechanism (10011) to move up and down in the upper furnace chamber (1001) and the lower furnace chamber (10012).

2. The artificial crystal furnace according to claim 1, **characterized in that** the lifting and lowering apparatus comprises at least one lifting and lowering arm (1007) connected to the crystal cooling mechanism (10011) and an elevator (1004) for driving the lifting and lowering arm (1007) to move up and down.

3. The artificial crystal furnace according to claim 2, **characterized in that** the lifting and lowering apparatus is provided with a cooling medium channel, and the crystal cooling mechanism (10011) is provided with a cooling channel for cooling medium flow, the cooling medium channel being in fluid communication with the cooling channel.

4. The artificial crystal furnace according to claim 2, **characterized in that** the lifting and lowering arm (1007) is provided in a linear structure or a fold-line-shaped structure.

5. The artificial crystal furnace according to claim 2 or 3, **characterized in that** two lifting and lowering arms (1007) are provided.

6. The artificial crystal furnace according to claim 3, **characterized in that** the cooling medium channel is provided on a side wall of the lifting and lowering arm (1007) or in a hollow structure of the lifting and lowering arm (1007).

7. The artificial crystal furnace according to claim 4, **characterized in that** the lifting and lowering arm (1007) is provided in a fold-line-shaped structure; at least one linear groove (1006) penetrating through an inner wall of the upper furnace chamber is provided on an outer edge face of the upper furnace chamber (1001); a cover body (1005) is provided on the outer edge face of the upper furnace chamber (1001) at a periphery of the linear groove (1006); and the fold-line segment of the lifting and lowering arm (1007) moves up and down in the linear groove (1006).

8. The artificial crystal furnace according to claim 2, **characterized in that** the upper furnace chamber (1001) is provided with at least one lifting and lowering arm cavity (10029) on an outer edge face of the upper furnace chamber (1001); an inner cavity of the lifting and lowering arm cavity (10029) is provided integrally with an inner cavity of the upper furnace chamber (1001); and the lifting and lowering arm (1007) is provided to be capable of moving up and down in a cavity formed by the inner cavity of the lifting and lowering arm cavity (10029) and the inner cavity of the upper furnace chamber (1001).

9. The artificial crystal furnace according to claim 4, **characterized in that** the lifting and lowering arm (1007) is provided in a rectilinear structure, an upper end of the lifting and lowering arm (1007) being connected to the elevator (1004) by penetrating through a top of the upper furnace chamber (1001).

10. The artificial crystal furnace according to claim 2 or 3, **characterized in that** the elevator (1004) comprises a hydraulic cylinder, an air cylinder, an electric push rod, a lead screw elevator, and an elevator for flexible shaft.

11. The artificial crystal furnace according to claim 2, **characterized in that** the elevator (1004) comprises a lifting and lowering block (1002), a power source (10019), a support frame (10020), a guide column (10021), a lead screw (10022), and a nut (10022), wherein the support frame (10020) is provided on an outer side of the upper furnace chamber (1001); two parallel guide columns (10021) are provided on the support frame (10020); the lifting and lowering block (1002) is provided on two guide columns (10021); the nut (10023) is provided on the lifting and lowering block (1002); the nut (10023) is sleeved on the lead screw (10022); an upper end and a lower end of the lead screw (10022) are respectively provided at an upper end and a lower end of the support frame (10020); the lead screw (10022) is connected to the power source (10019); and the lifting and lowering block (1002) is connected to the lifting and lowering arm (1007).

12. The artificial crystal furnace according to claim 2, **characterized in that** the elevator comprises a lifting and lowering block (1002), a power source (10019), a support frame (10020), a guide column (10021), an elevator for flexible shaft (10027), and a flexible shaft (10028), wherein the support frame (10020) is provided o an outer side of the upper furnace chamber (1001); two parallel guide columns (10021) are provided on the support frame (10020); the lifting and lowering block (1002) is provided on the two guide columns (10021); the flexible shaft (10028) is provided on the lifting and lowering block (1002) in a middle of two guide columns (10021); the flexible shaft (10028) is connected to the elevator for flexible shaft (10027) provided on the support frame (10020); the elevator for flexible shaft (10027) is externally connected to the power source (10019); and the lifting and lowering block (1002) is connected to the lifting and lowering arm (1007).

13. The artificial crystal furnace according to claim 11 or 12, **characterized in that** the guide column (10021) comprises a linear guide rail, a linear bearing, and a guide feed rod.

14. The artificial crystal furnace according to any one of claims 1 to 4, **characterized in that** the valve comprises a gate valve (1009), a rotary plate valve, and a flap valve.

15. The artificial crystal furnace according to any one of claims 2 to 4, **characterized in that** a sealing body is provided between outer edge faces of the upper furnace chamber (1001) and the lifting and lowering arm (1007).

16. The artificial crystal furnace according to any one of claims 2 to 4, **characterized in that** a bellows (1003) is sleeved on an outer edge face of the lifting and lowering arm (1007), wherein one end of the bellows (1003) is connected to the upper furnace chamber (1001), and the other end of the bellows (1003) is connected to the elevator (1004).

17. The artificial crystal furnace according to claim 1, **characterized in that** a cooling jacket (100019) is provided in connection between the crystal cooling mechanism (10011) and the lifting and lowering apparatus, the cooling jacket (100019) being used for cooling the crystal.

18. The artificial crystal furnace according to claim 17, **characterized in that** the lifting and lowering apparatus comprises at least one lifting and lowering arm (1007) and an elevator (1004) for driving the lifting and lowering arm (1007) to move up and down; wherein an upper end of the cooling jacket (100019) is connected to the lifting and lowering arm (1007), and a lower end of the cooling jacket (100019) is connected to the crystal cooling mechanism (10011); and an upper end of the lifting and lowering arm (1007) is connected to the elevator (1004).

19. The artificial crystal furnace according to claim 18, **characterized in that** a cooling medium channel is provided in the lifting and lowering arm (1007), the cooling medium channel being in series communication with a medium channel of the cooling jacket (100019) and a cooling channel of the crystal cooling mechanism (10011).

20. The artificial crystal furnace according to claim 18, **characterized in that** a cooling medium channel is provided in the lifting and lowering arm (1007), the cooling medium channel being in parallel communication with a medium channel of the cooling jacket (100019) and a cooling channel of the crystal cooling mechanism (10011).

21. The artificial crystal furnace according to any one of claims 17 to 20, **characterized in that** the cooling jacket (100019) comprises an upper cover plate (1903), a cooling jacket outer ring (1905), a cooling jacket inner ring (1906), and a lower cover plate (1907), wherein the cooling jacket outer ring (1905) is sleeved at a periphery of the cooling jacket inner ring (1906); the upper cover plate (1903) is provided at an upper end of a cavity between the cooling jacket outer ring (1905) and the cooling jacket inner ring (1906); the lower cover plate (1907) is provided at a lower end of the cavity between the cooling jacket outer ring (1905) and the cooling jacket inner ring (1906); and an upper inlet for the cooling medium (1901) and an upper outlet for the cooling medium (1904) are provided on the upper cover plate (1903).

22. The artificial crystal furnace according to claim 21, **characterized in that** the lower cover plate (1907) is provided with a lower outlet for the cooling medium (1902) and a lower inlet for the cooling medium (1908).

23. The artificial crystal furnace according to claim 21, **characterized in that** the cooling jacket (100019) further comprises a plurality of flow guide plates (1909) provided at intervals in the cavity between the cooling jacket outer ring (1905) and the cooling jacket inner ring (1906), upper end heads of the plurality of flow guide plates (1909) being provided to contact the upper cover plate (1903) in cavities at positions before and after the upper inlet for the cooling medium (1901) and the upper outlet for the cooling medium (1904).

24. The artificial crystal furnace according to claim 21, **characterized in that** the cooling jacket (100019) further comprises a spiral flow guide plate (1911) and a cooling medium return pipe (1910) provided in the cavity between the cooling jacket outer ring (1905) and the cooling jacket inner ring (1906), the upper outlet for the cooling medium (1904) being connected to the cooling medium return pipe (1910), and a lower end head of the cooling medium return pipe (1910) passing through the spiral flow guide plate (1911) and being located in a lower middle portion of the cavity between the cooling jacket outer ring (1905) and the cooling jacket inner ring (1906).

25. The artificial crystal furnace according to claim 22, **characterized in that** the cooling jacket (100019) further comprises a spiral flow guide plate (1911) and a cooling medium flow guide pipe (1912) provided in the cavity between the cooling jacket outer ring (1905) and the cooling jacket inner ring (1906), the upper outlet for the cooling medium (1904) being connected to the cooling medium flow guide pipe (1912), and a lower end of the cooling medium flow guide pipe (1912) being connected to the lower inlet for the cooling medium (1908) by penetrating through the spiral flow guide plate (1911).

26. The artificial crystal furnace according to any one of claims 17 to 20, **characterized in that** the cooling jacket (100019) comprises an upper cover plate (1903), a cooling jacket outer ring (1905), a cooling jacket inner ring (1906), and a lower cover plate (1907), wherein the cooling jacket outer ring (1905) is sleeved at a periphery of the cooling jacket inner ring (1906); the upper cover plate (1903) is provided at an upper end of a cavity between the cooling jacket outer ring (1905) and the cooling jacket inner ring (1906); the lower cover plate (1907) is provided at a lower end of a cavity between the cooling jacket outer ring (1905) and the cooling jacket inner ring (1906); an upper inlet for the cooling medium (1901) and an upper outlet for the cooling medium (1904) are provided on an outer edge face of the cooling jacket outer ring (1905); and a lower outlet for the cooling medium (1902) and a lower inlet for the cooling medium (1908) are provided on the lower cover plate (1907).

27. An artificial crystal furnace system, **characterized in that** the artificial crystal furnace system comprises the artificial crystal furnace according to any one of claims 1 to 26.
